# EUROPEAN PATENT APPLICATION

(11) **EP 4 646 058 A1**
(43) Date of publication of application: **05.11.2025**
(21) Application number: 25171596.7
(22) Date of filing: 22.04.2025
(51) Int. Cl.: H10F 10/14, H10F 19/75

(54) **SOLAR CELL, METHOD FOR FORMING THE SAME, AND PHOTOVOLTAIC MODULE**

(30) Priority: 29.04.2024 CN 202410532841; 29.04.2024 CN 202410533463
(71) Applicant: Jinko Solar (Shangrao) Co., Ltd, Shangrao, Jiangxi (CN); Jinko Solar (Haining) Co., Ltd., Haining City, Zhejiang 314415 (CN)
(72) Inventor: ZHANG, Xinyu, Shangrao, Jiangxi Province (CN); ZHENG, Jingming, Shangrao, Jiangxi Province (CN); WANG, Zhao, Shangrao, Jiangxi Province (CN); ZHENG, Peiting, Shangrao, Jiangxi Province (CN); YANG, Jie, Shangrao, Jiangxi Province (CN)
(74) Representative: Germain Maureau

(57) **Abstract**

The present disclosure provides a solar cell, a method for forming a solar cell, and a photovoltaic module. The solar cell includes: a semiconductor substrate including a front surface, a rear surface, and at least one side surface, the front surface and the rear surface being opposite to each other, and the side surface being arranged between the front surface and the rear surface; a first diffusion layer located inside or on the front surface of the semiconductor substrate; a second diffusion layer located inside or on the rear surface of the semiconductor substrate, the first diffusion layer and the second diffusion layer having opposite conductivity types; a third diffusion layer and a fourth diffusion layer that are located on the at least one side surface, the third diffusion layer and the fourth diffusion layer having opposite conductivity types, and the third diffusion layer and the fourth diffusion layer being in contact with each other; a first electrode forming ohmic contact with the first diffusion layer; and a second electrode forming ohmic contact with the second diffusion layer.

## Description

### TECHNICAL FIELD

The present disclosure relates to the field of photovoltaic production, and in particular, to a solar cell, a method for forming a solar cell, and a photovoltaic module.

### BACKGROUND

A solar cell is a device used to convert solar radiation directly to be electrical energy. For a solar cell, an individual cell usually cannot be directly used as a power supply, instead, a number of individual cells must be connected in series, in parallel, and tightly encapsulated into a photovoltaic module before being used.

During the use of the photovoltaic module, once an abnormal problem occurs in a certain cell (which is for example regarded as a faulty cell) to cause a cell current of this cell to be decreased, a current of a cell string formed by multiple cells connected in series with this faulty cell will be decreased, as a result, the power of this cell string makes almost no contribution to the power of the photovoltaic module, thereby reducing the overall output power of the photovoltaic module.

### SUMMARY

The present disclosure provides a solar cell, a method for forming a solar cell, and a photovoltaic module. By applying the solar cell to the photovoltaic module, the solar cell in an abnormal operation state has a decreased influence on the entire photovoltaic module, thereby improving the overall output power of the photovoltaic module.

In a first aspect, some embodiments of the present disclosure provide a solar cell including: a semiconductor substrate including a front surface, a rear surface, and at least one side surface, the front surface and the rear surface being opposite to each other, and the at least one side surface being arranged between the front surface and the rear surface; a first diffusion layer located inside or on the front surface of the semiconductor substrate; a second diffusion layer located inside or on the rear surface of the semiconductor substrate, the first diffusion layer and the second diffusion layer having opposite conductivity types; a third diffusion layer and a fourth diffusion layer that are located on the at least one side surface, the third diffusion layer and the fourth diffusion layer having opposite conductivity types, and the third diffusion layer and the fourth diffusion layer being in contact with each other; a first electrode forming ohmic contact with the first diffusion layer; and a second electrode forming ohmic contact with the second diffusion layer.

In some embodiments, the third diffusion layer and the fourth diffusion layer are arranged along a first direction, and the first direction is parallel to a thickness direction of the semiconductor substrate; the third diffusion layer is in contact with the first diffusion layer; and/or the fourth diffusion layer is in contact with the second diffusion layer.

In some embodiments, a dimension of the third diffusion layer along the first direction is represented by L1, and a dimension of the fourth diffusion layer along the first direction is represented by L2, where L1/L2=(0.5 to 1.5):1.

In some embodiments, a contact area between the third diffusion layer and the fourth diffusion layer is represented by S1, and an area of the side surface of the semiconductor substrate in contact with the third diffusion layer and the fourth diffusion layer is represented by S0, where S1/S0=(0.1 to 0.9):1.

In some embodiments, the third diffusion layer and the fourth diffusion layer are arranged along a second direction, and the third diffusion layer and the fourth diffusion layer at least partially overlap with each other, the third diffusion layer is located between the semiconductor substrate and the fourth diffusion layer, or the fourth diffusion layer is located between the semiconductor substrate and the third diffusion layer; the third diffusion layer is in contact with the first diffusion layer, and/or the third diffusion layer is in contact with the second diffusion layer; the fourth diffusion layer is in contact with the first diffusion layer, and/or the fourth diffusion layer is in contact with the second diffusion layer; and the second direction is perpendicular to the first direction, and the second direction is perpendicular to the thickness direction of the semiconductor substrate.

In some embodiments, a sum of a dimension of the third diffusion layer along the second direction and a dimension of the fourth diffusion layer along the second direction is within a range from 0.1 µm to 8 µm.

In some embodiments, a contact area between the third diffusion layer and the fourth diffusion layer is represented by S2, and an area of the side surface of the semiconductor substrate in contact with the third diffusion layer or the fourth diffusion layer is represented by S3, where S2/S3=(0.1 to 1):1.

In some embodiments, the third diffusion layer includes a doping element, and a doping concentration of the third diffusion layer is within a range from 1*E17cm⁻³ to 5*E21cm⁻³; and/or the fourth diffusion layer includes a doping element, and a doping concentration of the fourth diffusion layer is within a range from 1*E17cm⁻³ to 5*E21cm⁻³.

In some embodiments, the third diffusion layer includes a third sublayer a and a third sublayer b, the third sublayer a is farther away from the semiconductor substrate than the third sublayer b, and a doping concentration of the third sublayer a is less than a doping concentration of the third sublayer b; and/or the fourth diffusion layer includes a fourth sublayer a and a fourth sublayer b, the fourth sublayer a is farther away from the semiconductor substrate than the fourth sublayer b, and a doping concentration of the fourth sublayer a is lower than a doping concentration of the fourth sublayer b.

In some embodiments, a dimension of the third diffusion layer along a second direction is within a range from 0.05 µm to 5 µm; and/or a dimension of the fourth diffusion layer along a second direction is within a range from 0.05 µm to 5 µm.

In some embodiments, the third diffusion layer and the first diffusion layer have a same conductivity type; and/or the fourth diffusion layer and the second diffusion layer have a same conductivity type.

In some embodiments, the third diffusion layer and/or the fourth diffusion layer has an uneven surface.

In some embodiments, a leakage current of the solar cell is greater than or equal to 1A at any voltage condition from 1V to 30V.

In a second aspect, some embodiments of the present disclosure provide a method for forming a solar cell, including: providing a semiconductor substrate including a front surface, a rear surface, and at least one side surface, the front surface and the rear surface being opposite to each other, and the side surface being arranged between the front surface and the rear surface; forming a first diffusion layer on the front surface of the semiconductor substrate, forming a second diffusion layer on the rear surface of the semiconductor substrate, and forming a third diffusion layer and a fourth diffusion layer on the at least one side surface, the first diffusion layer and the second diffusion layer having opposite conductivity types, the third diffusion layer and the fourth diffusion layer having opposite conductivity types, and the third diffusion layer and the fourth diffusion layer being in contact with each other; and forming a first electrode on the front surface of the semiconductor substrate, and a forming second electrode on the rear surface of the semiconductor substrate.

In a third aspect, some embodiments of the present disclosure provide a photovoltaic module, including: a cover plate; an encapsulating material layer; and a solar cell string includes a plurality of the solar cells as described in the first aspect or a plurality of the solar cells formed by the method as described in the second aspect.

The technical solutions provided by the present disclosure can achieve the following beneficial effects.

In the present disclosure, the third diffusion layer and the fourth diffusion layer having opposite conductivity types are provided on the side surface of the semiconductor substrate, and the third diffusion layer and the fourth diffusion layer are in contact with each other. During a normal operation of the solar cell, since the third diffusion layer and the fourth diffusion layer are provided on the side surface of the semiconductor substrate and in contact with each other, the third diffusion layer and the fourth diffusion layer in contact with each other act as a diode to achieve unidirectional conduction, and at the same time have a large leakage current. If the solar cell is in an abnormal operation state (for example, when the solar cell is partially blocked or fails), the diode formed by the third diffusion layer and the fourth diffusion layer is caused to enter a reverse bias. At this time, the third diffusion layer and the fourth diffusion layer in contact with each other are equivalent to a resistor device, which allows current to pass through, so that when the current flows through a cell string including the solar cell, the cell string operation current can bypass the solar cell in the abnormal operation state to continue to flow through other solar cells directly through the path formed by the third diffusion layer and the fourth diffusion layer, without affecting the use of the other solar cells, and at the same time, the other solar cells can also be protected from higher positive voltage bias. That is, when the solar cell of the present disclosure is applied to a photovoltaic module, the solar cell in the abnormal operation state can be removed/omitted from the cell string in which it is located, thereby ensuring the overall output power of the cell string in which the solar cell is located. The solar cell of the present disclosure has excellent photoelectric conversion efficiency while ensuring the overall output power of the photovoltaic module to which the solar cell is applied. Moreover, the present disclosure provides the third diffusion layer and the fourth diffusion layer in contact with each other directly on the side surface of the solar cell, which will not significantly increase a size of the photovoltaic module which is formed by the solar cell, and can effectively improve the comprehensive gain of the photovoltaic module.

It should be understood that the foregoing general description and the following detailed description are exemplary only and cannot limit the present disclosure.

### BRIEF DESCRIPTION OF ACCOMPANYING DRAWINGS

FIG. 1 is a structural schematic diagram of a solar cell according to some embodiments of the present disclosure;
FIG. 2 is a structural schematic diagram of a semiconductor substrate according to some embodiments of the present disclosure;
FIG. 3 is a structural schematic diagram of a solar cell according to some embodiments of the present disclosure;
FIG. 4 is a structural schematic diagram of a part of a solar cell according to some embodiments of the present disclosure;
FIG. 5 is a structural schematic diagram of a solar cell including a passivation layer according to some embodiments of the present disclosure;
FIG. 6 is a structural schematic diagram of a solar cell including a passivation layer according to some embodiments of the present disclosure;
FIG. 7 is a structural schematic diagram of a solar cell according to some embodiments of the present disclosure;
FIG. 8 is a structural schematic diagram of a solar cell according to some embodiments of the present disclosure;
FIG. 9 is a structural schematic diagram of a solar cell according to some embodiments of the present disclosure;
FIG. 10 is a structural schematic diagram illustrating a side surface of a solar cell according to some embodiments of the present disclosure;
FIG. 11 is a structural schematic diagram of a part of a solar cell according to some embodiments of the present disclosure;
FIG. 12 is a structural schematic diagram of a solar cell including a passivation layer according to some embodiments of the present disclosure
FIG. 13 is a flow chart of a method for forming a solar cell according to some embodiments of the present disclosure;
FIG. 14 is a structural schematic diagram of forming a diffusion layer at each of a front surface, a rear surface, and at least one side surface of a semiconductor substrate according to some embodiments of the present disclosure;
FIG. 15 is a structural schematic diagram of forming a passivation layer at each of a front surface, a rear surface, and at least one side surface of a semiconductor substrate according to some embodiments of the present disclosure;
FIG. 16 is a flow chart of a method for forming a solar cell according to some embodiments of the present disclosure;
FIG. 17 is a structural schematic diagram of forming a diffusion layer at each of a front surface, a rear surface, and at least one side surface of a semiconductor substrate according to some embodiments of the present disclosure;
FIG. 18 is a structural schematic diagram of forming a passivation layer at each of a front surface, a rear surface, and at least one side surface of a semiconductor substrate according to some embodiments of the present disclosure; and
FIG. 19 is a structural schematic diagram of a photovoltaic module according to some embodiments of the present disclosure.

Reference numerals:
1-semiconductor substrate;
   1A-front surface;
   1B-rear surface;
   1C-side surface;
2-first diffusion layer;
3-second diffusion layer;
4-third diffusion layer;
   41-third sublayer a;
   42-third sublayer b;
5-fourth diffusion layer;
   51-fourth sublayer a;
   52-fourth sublayer b;
6-first passivation layer;
7-second passivation layer;
8-third passivation layer;
9-fourth passivation layer;
10-first electrode;
11-second electrode;
1000-photovoltaic module;
   100-solar cell;
   200-first cover plate;
   300-first encapsulation adhesive layer;
   400-second encapsulation adhesive layer;
   500-second cover plate.

The accompanying drawings herein, which are incorporated in and constitute a part of this specification, show some embodiments consistent with the present disclosure and, together with the description, serve to explain the principles of the present disclosure.

### DESCRIPTION OF EMBODIMENTS

To make the objectives, technical solutions, and advantages of the present disclosure more clearly understood, the present disclosure is further described in detail below in conjunction with the accompanying drawings and embodiments. It should be understood that the specific embodiments described herein are only used to explain the present disclosure and are not used to limit the present disclosure.

In the description of the present disclosure, the term such as "first" and "second" are used for descriptive purposes only and cannot be construed as indicating or implying relative importance; unless otherwise explicitly specified or indicated, the term "multiple/a plurality of" means two or more; and the term such as "connection", "fixation" and the like are to be construed in a broad sense, for example, a "connection" may be a fixed connection, a detachable connection, or an integral connection, an electrical connection, a direct connection, or an indirect connection through an intermediate element. For those ordinarily skilled in the art, the specific meanings of the above-mentioned terms in the present disclosure can be understood according to the specific circumstances.

In the description of the present disclosure, it should be noted that the directional words such as "upper", "lower", "above", "below" and the like described in the embodiments of the present disclosure are described at the perspective shown in the accompanying drawings, and should not be understood as limiting the embodiments of the present disclosure. Further, in this context, it should be understood that when referring to an element being connected "above" or "below" another element, the element can not only be directly connected "above" or "below" the another element, but the element can also be indirectly connected "above" or "below" the another element via an intermediate element.

In the related art, since an individual cell cannot be used directly as a power supply, a plurality of individual cells are usually connected to form a photovoltaic module for power generation to realize the conversion of solar energy to be electrical energy. A photovoltaic module are usually composed of several to dozens or even hundreds of individual solar cells connected in series and in parallel. If any one of the solar cells in the photovoltaic module is blocked by shadow, dust, bird droppings, snow, buildings, or other obstacles, this solar cell will be caused to heat up and a hot spot effect will occur, causing a cell current of this solar cell to decrease, affecting the output power of the solar cell, and in turn affecting the cell current of the multiple other solar cells connected in series with this solar cell, causing the cell power of the cell string in which the solar cell is arranged to contribute almost nothing to the power of the photovoltaic module, thereby causing the output power of the photovoltaic module to be greatly reduced and difficult to maintain normal operation conditions, and even affecting the overall output power of the entire photovoltaic module.

In view of this, an embodiment of the present disclosure provides a solar cell, in which a third diffusion layer and a fourth diffusion layer in contact with each other and having opposite conductivity types are provided on at least one side surface of the solar cell, so that the side surface of the solar cell acts as a resistor device in an abnormal operation state, thereby allowing a current to pass through, so that when the current flows through a cell string including this solar cell, the cell string operation current can bypass this solar cell in the abnormal operation state to continue to flow through other solar cells directly through the path formed by the third diffusion layer and the fourth diffusion layer, without affecting the use of the other solar cells, and at the same time, the other solar cells can also be protected from higher positive voltage bias.

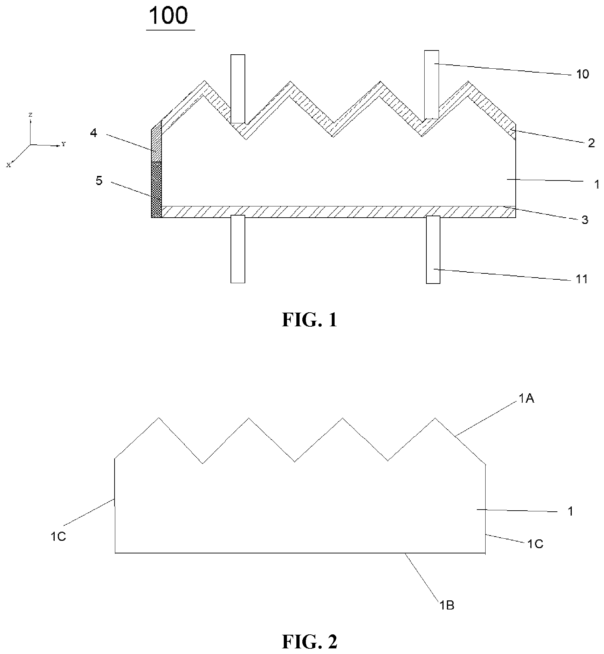

FIG. 1 shows a structural schematic diagram of a solar cell according to some embodiments of the present disclosure, and FIG. 2 shows a structural schematic diagram of a semiconductor substrate according to some embodiments of the present disclosure. With reference to FIG. 1 and FIG. 2, the solar cell provided by the present disclosure includes: a semiconductor substrate 1, a first diffusion layer 2, a second diffusion layer 3, a third diffusion layer 4, a fourth diffusion layer 5, at least one first electrode 10, and at least one second electrode 11. The semiconductor substrate 1 includes a front surface 1A, a rear surface 1B, and at least one side surface 1C. The front surface 1A and the rear surface 1B are provided opposite to each other, and the side surface 1C is provided between the front surface 1A and the rear surface 1B. The first diffusion layer 2 is provided inside or on the front surface 1A of the semiconductor substrate 1. The second diffusion layer 3 is provided inside or on the rear surface 1B of the semiconductor substrate 1, and the first diffusion layer 2 and the second diffusion layer 3 have opposite conductivity types. The third diffusion layer 4 and the fourth diffusion layer 5 are provided on the at least one side surface 1C, and the third diffusion layer 4 and the fourth diffusion layer 5 have opposite conductivity types. The third diffusion layer 4 and the fourth diffusion layer 5 are arranged along a first direction Z and in contact with each other, and the first direction Z is parallel to a thickness direction of the semiconductor substrate 1, the first electrode 10 forms ohmic contact with the first diffusion layer 2; and second electrode 11 forms ohmic contact with the second diffusion layer 3.

In the above-described solution, in some embodiments of the present disclosure, the third diffusion layer 4 and the fourth diffusion layer 5 having opposite conductivity types are provided on the side surface 1C of the semiconductor substrate 1, and the third diffusion layer 4 and the fourth diffusion layer 5 are arranged along a Z-axis direction (i.e., first direction) shown in FIG. 1 and in contact with each other. During a normal operation of the solar cell, since the third diffusion layer 4 and the fourth diffusion layer 5 are provided on the side surface 1C of the semiconductor substrate 1 and in contact with each other, the third diffusion layer 4 and the fourth diffusion layer 5 in contact with each other act as a diode to achieve unidirectional conduction, and at the same time have a large leakage current. If the solar cell is in an abnormal operation state (for example, when the solar cell is partially blocked or fails), the diode formed by the third diffusion layer 4 and the fourth diffusion layer 5 is caused to enter a reverse bias. At this time, the third diffusion layer 4 and the fourth diffusion layer 5 in contact with each other are equivalent to a resistor device, which allows a current to pass through, so that when the current flows through a cell string including the solar cell, the cell string operation current can bypass the solar cell in the abnormal operation state to continue to flow through other solar cells directly through the path formed by the third diffusion layer 4 and the fourth diffusion layer 5, without affecting the use of the other solar cells, and at the same time, the other solar cells can also be protected from higher positive voltage bias. That is, when the solar cell according to some embodiments of the present disclosure is applied to a photovoltaic module, the solar cell in the abnormal operation state can be removed/omitted from the cell string in which it is arranged, thereby ensuring the overall output power of the cell string in which the solar cell is located. The solar cell according to the present disclosure has excellent photoelectric conversion efficiency while ensuring the overall output power of the photovoltaic module to which the solar cell is applied. Moreover, the present disclosure provides the third diffusion layer 4 and the fourth diffusion layer 5 in contact with each other directly on the side surface 1C of the solar cell, which will not significantly increase a size of the photovoltaic module which is formed by the solar cell, and can effectively improve the comprehensive gain of the photovoltaic module.

It can be understood that the solar cell of the present disclosure is provided with a PN junction formed between the first diffusion layer 2 or the second diffusion layer 3 and the semiconductor substrate 1, so that when the solar cell is under light irradiation conditions, under the action of the built-in electric field within the PN junction, the photo-generated carriers (electron-hole pairs) are effectively separated, so that the electrons and the holes are aggregated in different regions, thereby generating a current. And the third diffusion layer 4 and the fourth diffusion layer 5 in contact with each other are provided on the side surface 1C of the semiconductor substrate 1, which causes a smaller current during the normal operation of the solar cell, and has less or almost no effect on the absorption of sunlight by the solar cell, while the solar cell has a higher leakage current.

With further reference to FIG. 2, the semiconductor substrate 1 includes the front surface 1A and the rear surface 1B provided opposite to each other. The front surface 1A of the semiconductor substrate 1 refers to a light-receiving surface, that is, the surface that receives sunlight; and the rear surface 1B of the semiconductor substrate 1 refers to a surface opposite to the front surface 1A. Four side surfaces 1C are provided between the front surface 1A and the rear surface 1B, and are provided at a left side, a right side, a front side, and a back side of the semiconductor substrate 1, respectively. The four side surfaces 1C are connected head to tail to be surround the semiconductor substrate 1. It can be understood that FIG. 2 is a cross-section of a structural schematic diagram of the semiconductor substrate, and FIG. 2 only shows two of the side surfaces 1C. The present disclosure provides the third diffusion layer 4 and the fourth diffusion layer 5 in contact with each other on at least one side surface 1C, so that the solar cell has a higher leakage current, while not affecting the function of the PN junction of the solar cell, thereby ensuring the output power of the solar cell.

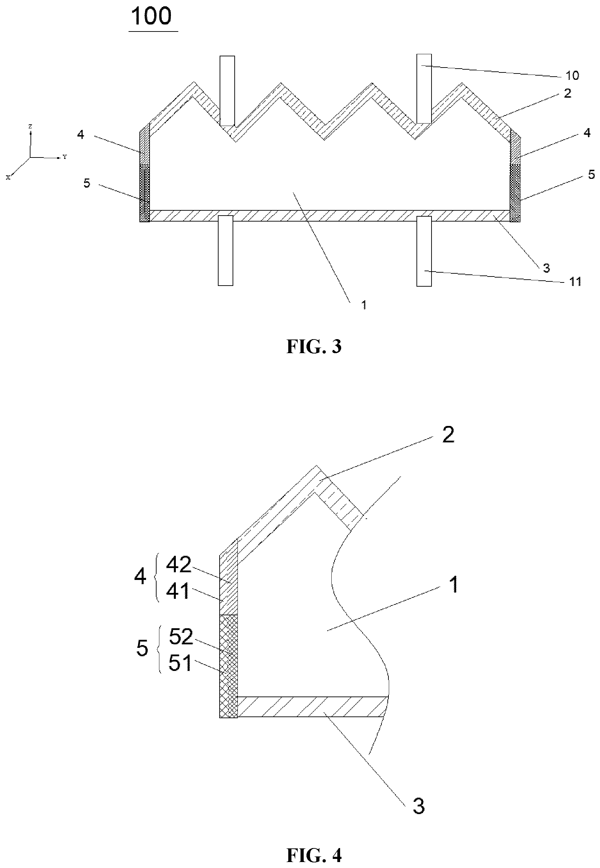

In some embodiments, when the solar cell is involved in the formation of the photovoltaic module In a form of a whole-piece cell, the third diffusion layer 4 and the fourth diffusion layer 5 in contact with each other may be provided on any one side surface 1C, two side surfaces 1C, three side surfaces 1C, or four side surfaces 1C of the solar cell. Exemplarily, with reference to FIG. 3, which shows a structural schematic diagram of the solar cell according to some embodiments of the present disclosure, the third diffusion layer 4 and the fourth diffusion layer 5 are provided on each of the left surface and the right surface of the semiconductor substrate 1.

In other embodiments, when the solar cell is involved in the formation of the photovoltaic module in a form of a half-cut cell, the third diffusion layer 4 and the fourth diffusion layer 5 in contact with each other may be provided on any one side surface 1C, two side surfaces 1C, or three side surfaces 1C of the solar cell, while the third diffusion layer 4 and the fourth diffusion layer 5 are not provided on one side surface. Exemplarily, as shown in FIG. 1, the third diffusion layer 4 and the fourth diffusion layer 5 are not provided on the right side surface of the semiconductor substrate 1 in FIG. 1.

In some embodiments, a leakage current of the solar cell is greater than or equal to 1A at any voltage condition from 1V to 30V. The voltage may be 1V, 3V, 5V, 8V, 10V, 15V, 23V, 25V or 30V, etc. In some embodiments of the present disclosure, the leakage current at the condition from 1V to 30V may be 1A, 1.2A, 1.5A, 1.8A, 2.3A, 2.8A, 3.5A, 4A, 5A, 6A, 7A or 8A, etc. A magnitude of the leakage current of the solar cell is closely related to the voltage and the resistivity of the cell, the doping concentration of the third diffusion layer 4, the doping concentration of the fourth diffusion layer 5, a thickness of the third diffusion layer 4, a thickness of the fourth diffusion layer, and a contact between the third diffusion layer 4 and the fourth diffusion layer 5. The embodiments of the present disclosure can adjust the above-mentioned factors according to the magnitude of the leakage current, in such a manner that the leakage current of the solar cell of the present disclosure is larger and reaches 1A or above.

Compared with a traditional solar cell, in which the leakage current of the cell is reduced by optimization of the quality of a silicon wafer, improvement of the formation process, etc. to avoid adverse consequences such as short circuit occurring in the cell, the present disclosure creatively provides the third diffusion layer 4 and the fourth diffusion layer 5 in contact with each other on the side surface 1C of the solar cell so that the leakage current of the solar cell can reach 1A or above (usually the leakage current of a conventional solar cell can only reach tens of milliamperes, which cannot form an excellent resistor device as provided by the present disclosure at an abnormal state of the solar cell), such that at an abnormal operation state of the solar cell, the third diffusion layer 4 and the fourth diffusion layer 5 can be transformed to be a resistor device to achieve bidirectional conduction of current, so that the current of the cell string including the solar cell is not affected, thereby improving the overall output power of the photovoltaic module formed by a plurality of the solar cells. Moreover, the third diffusion layer 4 and the fourth diffusion layer 5 are provided on the side surface of the cell, which does not affect the function of the PN junction of the solar cell, thereby ensuring the high cell efficiency of the solar cell. Exemplarily, for the leakage current of the solar cell in the present disclosure, it is possible to detect the leakage current of the solar cell by placing the solar cell under an external bias voltage of a DC regulated power supply and using an infrared thermal imager.

With further reference to FIG. 1, in some embodiments, a contact area between the third diffusion layer 4 and the fourth diffusion layer 5 is represented by S1, and an area of the side surface of the semiconductor substrate 1 in contact with the third diffusion layer 4 and the fourth diffusion layer 5 is represented by S0, where S1/S0=(0.1 to 0.9): 1, and for example can be 0.1:1, 0.2:1, 0.25:1, 0.35:1, 0.5:1, 0.6:1, 0.75:1, 0.8:1 or 0.9:1. Within the above-mentioned range, the leakage current of the solar cell of the present disclosure at any voltage condition from 1V to 30V can be greater than 1A, thereby improving the overall output power of the photovoltaic module prepared by a plurality of the solar cells. Preferably, S1/S0=(0.25 to 0.75):1.

With further reference to FIG. 1, in some embodiments, a dimension of the third diffusion layer 4 along the first direction Z is represented by L1, and a dimension of the fourth diffusion layer 5 along the first direction Z is represented by L2, where L1/L2=(0.5 to 1.5):1, and for example may be 0.5:1, 0.8:1, 1:1, 1.2:1, 1.4:1 or 1.5:1, etc. Within the above-mentioned range, the dimension of the third diffusion layer 4 along the first direction may be greater than, equal to, or less than the dimension of the fourth diffusion layer 5 along the first direction. Preferably, when the first diffusion layer 2 forms a PN junction with the semiconductor substrate 1 and the first diffusion layer 2 and the third diffusion layer 4 have a same conductivity type, L1 is greater than or equal to L2, that is, L1/L2=(1 to 1.5):1. When the second diffusion layer 3 forms a PN junction with the semiconductor substrate 1 and the second diffusion layer 3 and the fourth diffusion layer 5 have a same conductivity type, L1 is less than or equal to L2, that is, L1/L2=(0.5 to 1):1. It can be understood that when the first diffusion layer 2 and the third diffusion layer 4 have the same conductivity type, the third diffusion layer 4 will also form a PN junction with the semiconductor substrate 1 at the side surface 1C of the semiconductor substrate 1; and when the second diffusion layer 3 and the fourth diffusion layer 5 have the same conductivity type, the fourth diffusion layer 5 will also form a PN junction with the semiconductor substrate 1 at the side surface 1C of the semiconductor substrate 1, thereby being beneficial to the effective separation of photo-generated carriers, and thus improving the output power of the solar cell.

In some embodiments, the third diffusion layer 4 includes a doping element, and a doping concentration of the third diffusion layer 4 is 1*E17cm⁻³ to 5*E21cm⁻³, and for example may be 1*E17cm⁻³, 5*E17cm⁻³, 1*E18cm⁻³, 5*E18cm⁻³, 1*E19cm⁻³, 5*E19cm⁻³, 1*E20cm⁻³ or 5*E21cm⁻³, etc. Within the above-mentioned range, not only a contact resistance between the semiconductor substrate 1 and the electrode can be reduced and a series resistance of the cell can be reduced, but also the recombination of carriers can be reduced and the minority carrier lifetime can be increased, thereby increasing the open circuit voltage and short circuit current of the cell. The doping element in the third diffusion layer 4 is mainly related to the conductivity type of the third diffusion layer 4. If the conductivity type of the third diffusion layer 4 is P type, the doping element in the third diffusion layer 4 is a Group-IIIA element, for example boron, aluminum, gallium,, and the like. If the conductivity type of the third diffusion layer 4 is N-type, the doping element in the third diffusion layer 4 is a Group-V element, for example phosphorus, arsenic, antimony, and the like.

In some embodiments, the fourth diffusion layer 5 includes a doping element, and a doping concentration of the fourth diffusion layer 5 is 1*E17cm⁻³ to 5*E21cm⁻³, and for example may be 1*E17cm⁻³, 5*E17cm⁻³, 1*E18cm⁻³, 5*E18cm⁻³, 1*E19cm⁻³, 5*E19cm⁻³, 1*E20cm⁻³, or 5*E21cm⁻³, etc. Within the above-mentioned range, not only a contact resistance between the silicon wafer and the electrode can be reduced and a series resistance of the cell can be reduced, but also the recombination of carriers can be reduced and the minority carrier lifetime can be increased, thereby increasing the open circuit voltage and short circuit current of the cell. The doping element in the fourth diffusion layer 5 is mainly related to the conductivity type of the fourth diffusion layer 5. If the conductivity type of the fourth diffusion layer 5 is P type, the doping element in the fourth diffusion layer 5 is a Group-IIIA element, for example boron, aluminum, gallium, and the like. If the conductivity type of the fourth diffusion layer 5 is N type, the doping element in the fourth diffusion layer 5 is a Group-V element, for example phosphorus, arsenic, antimony, and the like.

In some embodiments, with reference to FIG. 4, the third diffusion layer 4 includes a third sublayer a41 and a third sublayer b42. The third sublayer a41 is farther away from the semiconductor substrate 1 than the third sublayer b42. A doping concentration of the third sublayer a41 is less than a doping concentration of the third sublayer b42. Therefore, the third sublayer b42 close to the semiconductor substrate 1 is a heavily doped region compared with the third sublayer a41. The heavily doped third sublayer b42 can provide a low-impedance electron or hole collection path, while forming a selective contact to reduce the recombination of carriers at the side surface 1C of the semiconductor substrate 1. In addition, the third sublayer a41 and the third sublayer b42 can form a gradient-doped structure, which is beneficial for collecting photo-generated carriers and improving the short circuit current of the solar cell.

In some embodiments, the doping concentration of the third sublayer a41 is 1*E17cm⁻³ to 1*E19cm⁻³, and for example may be 1*E17cm⁻³, 5*E17cm⁻³, 1*E18cm⁻³, 5*E18cm⁻³, or 1*E19cm⁻³, etc. The doping concentration of the third sublayer b42 is 1*E18cm⁻³ to 5*E21cm⁻³ , and for example may be 1*E18cm⁻³, 5*E18cm⁻³, 1*E19cm⁻³, 5*E19cm⁻³, 1*E20cm⁻³, or 5*E21cm⁻³, etc.

Correspondingly, with further reference to Figure 4, the fourth diffusion layer 5 includes a fourth sublayer b51 and a fourth sublayer b52. The fourth sublayer b51 is farther away from the semiconductor substrate 1 than the fourth sublayer b52, and a doping concentration of the fourth sublayer b51 is less than a doping concentration of the fourth sublayer b52. Therefore, the fourth sublayer b52 close to the semiconductor substrate 1 is a heavily doped region compared with the fourth sublayer b51. The heavily doped fourth sublayer b52 can provide a low-impedance electron or hole collection path, while forming a selective contact to reduce the recombination of carriers at the side surface 1C of the semiconductor substrate 1. In addition, the fourth sublayer b51 and the fourth sublayer b52 can form a gradient-doped structure, which is beneficial to collecting photo-generated carriers and improving the short circuit current of the solar cell.

In some embodiments, the doping concentration of the fourth sublayer b51 is 1*E17cm⁻³ to 1*E19cm⁻³, and for example may be 1*E17cm⁻³, 5*E17cm⁻³, 1*E18cm⁻³, 5*E18cm⁻³, or 1*E19cm⁻³, etc. The doping concentration of the fourth sublayer b52 is 1*E18cm⁻³ to 5*E21cm⁻³ , and for example may be 1*E18cm⁻³, 5*E18cm⁻³, 1*E19cm⁻³, 5*E19cm⁻³, 1*E20cm⁻³, or 5*E21cm⁻³, etc. Preferably, the third diffusion layer 4 and the fourth diffusion layer 5 each form a layer structure similar to gradient doping, which can reduce the recombination at the side surface 1C of the semiconductor substrate 1 and be beneficial to improving the photoelectric conversion efficiency of the solar cell.

With further reference to FIG. 1, in some embodiments, a dimension of the third diffusion layer 4 along a second direction Y is 0.05 µm to 5 µm, and for example may be 0.05 µm, 0.1 µm, 0.5 µm, 1 µm, 2 µm, 3 µm, 4 µm, or 5 µm, etc. The second direction is perpendicular to the first direction and perpendicular to the thickness direction of the semiconductor substrate 1. The second direction may be the Y-axis direction, that is, the dimension of the third diffusion layer 4 along the second direction Y is the thickness of the third diffusion layer 4. The thickness of the third diffusion layer 4 of the present disclosure is appropriate, which can ensure effective contact between the third diffusion layer 4 and the fourth diffusion layer 5, so that that the third diffusion layer 4 and the fourth diffusion layer 5 become an effective diode device during the normal operation of the solar cell, while increasing the recombination of carriers and reducing the overall efficiency of the solar cell, and ensuring that the solar cell has a high leakage current greater than or equal to 1A.

In some embodiments, a dimension of the fourth diffusion layer 5 along the second direction is 0.05 µm to 5 µm, and for example may be 0.05 µm, 0.1 µm, 0.5 µm, 1 µm, 2 µm, 3 µm, 4 µm or 5 µm, etc. The dimension of the fourth diffusion layer 5 along the second direction is the thickness of the fourth diffusion layer 5. The thickness of the fourth diffusion layer 5 of the present disclosure is appropriate, which can ensure effective contact between the third diffusion layer 4 and the fourth diffusion layer 5, so that that the third diffusion layer 4 and the fourth diffusion layer 5 become an effective diode device during the normal operation of the solar cell, while increasing the recombination of carriers and reducing the overall efficiency of the solar cell, and ensuring that the solar cell has a high leakage current greater than or equal to 1A.

In some embodiments, the first diffusion layer 2 and the second diffusion layer 3 have opposite conductivity types, the third diffusion layer 4 and the fourth diffusion layer 5 have opposite conductivity types, and the third diffusion layer 4 and the fourth diffusion layer 5 are arranged along the first direction parallel to the thickness direction of the semiconductor substrate 1. Exemplarily, the following description is made by taking the first direction as the opposite direction of the Z-axis direction shown in FIG. 1 as an example. As shown in FIG. 1, the third diffusion layer 4 and the fourth diffusion layer 5 are provided between the first diffusion layer 2 and the second diffusion layer 3, and the third diffusion layer 4 is closer to the first diffusion layer 2 than the fourth diffusion layer 5, and the fourth diffusion layer 5 is closer to the second diffusion layer 3 than the third diffusion layer 4.

In some embodiments, the conductivity types of the first diffusion layer 2 and the third diffusion layer 4 may be the same or opposite.

In some embodiments, the first diffusion layer 2 and the third diffusion layer 4 have the same conductivity type, and the second diffusion layer 3 and the fourth diffusion layer 5 have the same conductivity type. The first diffusion layer 2 and the third diffusion layer 4 can be regarded as a same diffusion layer, only with a difference in terms of the location. The second diffusion layer 3 and the fourth diffusion layer can be regarded as a same diffusion layer, only with a difference in terms of the location. Therefore, the third diffusion layer 4 and the fourth diffusion layer 5 having different conductivity types can form a diode device when the solar cell is in an normal operation state to achieve unidirectional conduction. Furthermore, since the third diffusion layer 4 and the fourth diffusion layer 5 are provided on the side surface 1C of the semiconductor substrate 1, they do not have a significant negative impact on the PN junction formed by the first diffusion layer 2 and the semiconductor substrate 1 or the PN junction formed by the third diffusion layer 4 and the semiconductor substrate 1.

In other embodiments, the first diffusion layer 2 and the third diffusion layer 4 have opposite conductivity types, and the second diffusion layer 3 and the fourth diffusion layer 5 have opposite conductivity types. Therefore, the third diffusion layer 4 and the fourth diffusion layer 5 still have different conductivity types. The third diffusion layer 4 and the fourth diffusion layer 5 having different conductivity types can form a diode device when the solar cell is in an normal operation state to achieve unidirectional conduction. Furthermore, since the third diffusion layer 4 and the fourth diffusion layer 5 are provided on the side surface 1C of the semiconductor substrate 1, they do not have a significant negative impact on the PN junction formed by the first diffusion layer 2 and the semiconductor substrate 1 or the PN junction formed by the third diffusion layer 4 and the semiconductor substrate 1.

In some embodiments, the third diffusion layer 4 and the first diffusion layer 2 are in contact with each other.

In some embodiments, the first diffusion layer 2 and the third diffusion layer 4 have the same conductivity type, and the third diffusion layer 4 and the first diffusion layer 2 can be regarded as an integrated structure, that is, the first diffusion layer 2 and the third diffusion layer 4 are formed in a same process. When the first diffusion layer 2 and the third diffusion layer 4 are formed in a same process, the doping element in the first diffusion layer 2 and the doping element in the third diffusion layer 4 are the same. Exemplarily, the first diffusion layer 2 and the third diffusion layer 4 each are a boron diffusion layer. In another case, the third diffusion layer 4 and the first diffusion layer 2 can be regarded as a split structure, that is, the first diffusion layer 2 and the third diffusion layer 4 are formed in different processes. When the first diffusion layer 2 and the third diffusion layer 4 are formed in different processes, the doping element in the first diffusion layer 2 and the doping element in the third diffusion layer 4 may be different from each other. Exemplarily, the third diffusion layer 4 is a boron diffusion layer, and the first diffusion layer 2 is an aluminum diffusion layer. In order to simplify the manufacturing process, the doping element in the first diffusion layer 2 and the doping element in the third diffusion layer 4 are the same.

In some other embodiments, the first diffusion layer 2 and the third diffusion layer 4 have opposite conductivity types, and the first diffusion layer 2 and the third diffusion layer 4 are formed in different processes. When the first diffusion layer 2 and the third diffusion layer 4 are in contact with each other, a diode device is formed therebetween.

In some embodiments, the fourth diffusion layer 5 and the second diffusion layer 3 are in contact with each other.

In some embodiments, the second diffusion layer 3 and the fourth diffusion layer 5 have the same conductivity type, and the fourth diffusion layer 5 and the second diffusion layer 3 can be regarded as an integrated structure, that is, the second diffusion layer 3 and the fourth diffusion layer 5 are formed in a same process. When the second diffusion layer 3 and the fourth diffusion layer 5 are formed in a same process, the doping element in the second diffusion layer 3 and the doping element in the fourth diffusion layer 5 are the same. Exemplarily, the first diffusion layer 2 and the third diffusion layer 4 each are a phosphorus diffusion layer. In another case, the fourth diffusion layer 5 and the second diffusion layer 3 can be regarded as a split structure, that is, the second diffusion layer 3 and the fourth diffusion layer 5 are formed in different processes. When the second diffusion layer 3 and the fourth diffusion layer 5 are formed in different processes, the doping element in the second diffusion layer 3 and the doping element in the fourth diffusion layer 5 are different from each other. Exemplarily, the second diffusion layer 3 is a phosphorus diffusion layer, and the first diffusion layer 2 is an arsenic diffusion layer. In order to simplify the manufacturing process, the doping element in the first diffusion layer 2 and the doping element in the third diffusion layer 4 are the same.

In some other embodiments, the first diffusion layer 2 and the third diffusion layer 4 have opposite conductivity types, and the first diffusion layer 2 and the third diffusion layer 4 are formed in different processes. When the first diffusion layer 2 and the third diffusion layer 4 are in contact with each other, a diode device is formed therebetween.

In some embodiments, the third diffusion layer 4 is a P-type diffusion layer, and the doping element in the P-type diffusion layer includes a Group-V element. The doping element in the P-type diffusion layer may be, for example, at least one of phosphorus (P), arsenic (As), or antimony (Sb). Correspondingly, the fourth diffusion layer 5 is an N-type diffusion layer, the doping element in the N-type diffusion layer includes a Group-III element, and the doping element in the P-type diffusion layer may be at least one of boron (B), aluminum (Al), gallium (Ga), or indium (In).

In some embodiments, the third diffusion layer 4 is an N-type diffusion layer, the doping element in the N-type diffusion layer includes a Group-III element, and the doping element in the P-type diffusion layer may be, for example, at least one of boron (B), aluminum (Al), gallium (Ga), or indium (In). The fourth diffusion layer 5 is a P-type diffusion layer. The doping element in the P-type diffusion layer includes a Group-V element. The doping element in the P-type diffusion layer may be, for example, at least one of phosphorus (P), arsenic (As), or antimony (Sb).

In some embodiments, the third diffusion layer 4 has an uneven surface. It can be understood that the surface of the third diffusion layer 4 refers to a surface of the third diffusion layer 4 facing away from the semiconductor substrate 1. The uneven surface of the third diffusion layer 4 can increase the absorption and utilization of sunlight by the side surface 1C of the semiconductor substrate 1, which is beneficial to stimulate more electron-hole pairs, increase the photo-generated current of the solar cell, and improve the conversion efficiency of the solar cell.

In some embodiments, the fourth diffusion layer 5 has an uneven surface. It can be understood that the surface of the fourth diffusion layer 5 refers to a surface of the fourth diffusion layer 5 facing away from the semiconductor substrate 1. The uneven surface of the fourth diffusion layer 5 can increase the absorption and utilization of sunlight by the side surface 1C of the semiconductor substrate 1, which is beneficial to stimulate more electron-hole pairs, increase the photo-generated current of the solar cell, and improve the conversion efficiency of the solar cell.

In some embodiments, the third diffusion layer 4 has a patterned structure. The third diffusion layer 4 having the patterned structure helps to reduce local overheating or current concentration problems that may occur during the operation of the cell, thereby improving the reliability and lifetime of the cell. Moreover, due to the patterned structure, the use of metal materials can be reduced and costs can be reduced.

In some embodiments, the fourth diffusion layer 5 has a patterned structure. The fourth diffusion layer 5 having the patterned structure helps to reduce local overheating or current concentration problems that may occur during operation of the cell, thereby improving the reliability and lifetime of the cell. Moreover, due to the patterned structure, the use of metal materials can be reduced and costs can be reduced.

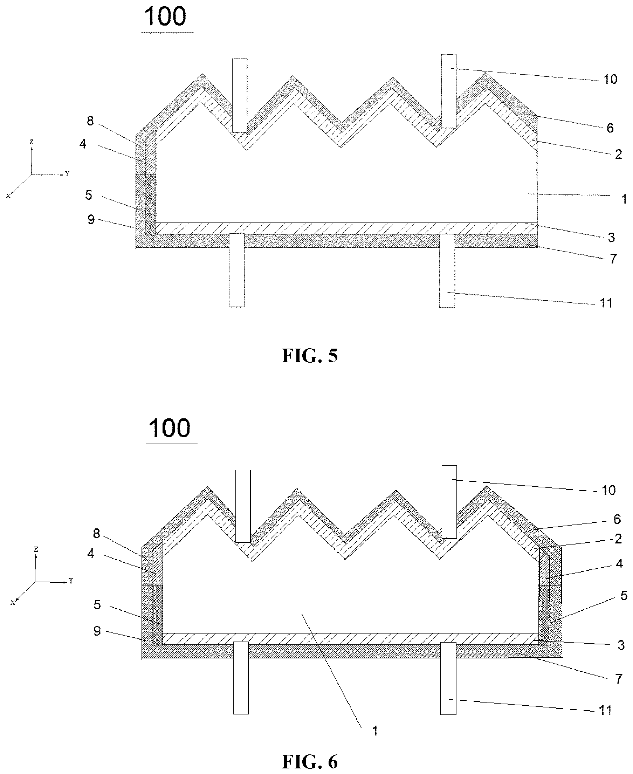

In some embodiments, with reference to FIG. 5 and FIG. 6, the solar cell further includes a first passivation layer 6 provided on a surface 1C of the first diffusion layer 2 facing away from the semiconductor substrate 1, and a second passivation layer 7 provided on a surface 1C of the second diffusion layer 3 facing away from the semiconductor substrate 1. The provision of the first passivation layer 6 and the second passivation layer 7 can reduce dangling bonds and defect states at the surfaces of the cell, effectively reduce the recombination rate of carriers at the surface of the semiconductor substrate 1, and improve the open circuit voltage (Voc) and fill factor (FF) of the cell, thereby improving the overall conversion efficiency of the cell.

In some embodiments, with further reference to FIG. 5 and FIG. 6, the solar cell further includes a third passivation layer 8 provided on a surface 1C of the third diffusion layer 4 facing away from the semiconductor substrate 1, and a fourth passivation layer 9 provided on a surface 1C of the fourth diffusion layer 5 facing away from the semiconductor substrate 1. The side surface 1C or an edge region is a hotspot for carrier recombination in a solar cell because this region usually has more defects and dangling bonds, which lead to non-radiative recombination of carriers, thereby reducing the efficiency of the cell. The present disclosure can reduce the recombination rate at the side surface 1C of the semiconductor substrate 1 and improve the efficiency of the solar cell by providing the third passivation layer 8 and the fourth passivation layer 9.

In some embodiments, the material of the third passivation layer 8 may be the same as or different from the material of the first passivation layer 6. Preferably, the material of the third passivation layer 8 is the same as the material of the first passivation layer 6. In this case, the third passivation layer 8 and the first passivation layer 6 can be regarded as an integrated structure. Correspondingly, the material of the fourth passivation layer 9 may be the same as or different from the material of the second passivation layer 7. Preferably, the materials of the fourth passivation layer 9 is the same as the material of the second passivation layer 7. In this case, the fourth passivation layer 9 and the second passivation layer 7 can be regarded as an integrated structure.

As described above, in some embodiments of the present disclosure, the third diffusion layer and the fourth diffusion layer may be arranged along the first direction and in contact with each other. In some other embodiments of the present disclosure, the third diffusion layer and the fourth diffusion layer may be arranged along a second direction and in contact with each other, and the second direction is perpendicular to the first direction and perpendicular to the thickness direction of the semiconductor substrate. The following will describe a situation where the third diffusion layer and the fourth diffusion layer are arranged along the second direction.

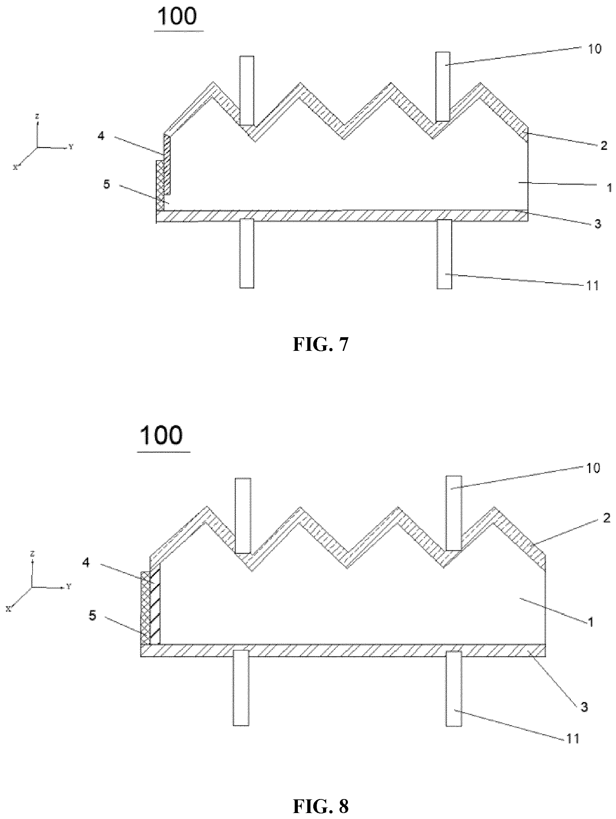

With reference to FIG. 7 and FIG. 8, the third diffusion layer 4 and the fourth diffusion layer 5 may be arranged along the second direction Y, and the third diffusion layer 4 and the fourth diffusion layer 5 may at least partially overlap with each other. The third diffusion layer 4 and the fourth diffusion layer 5 at least partially overlapping with each other means that the third diffusion layer 4 and the fourth diffusion layer 5 are in contact with each other and have a shared area. In some embodiments, the third diffusion layer 4 and the fourth diffusion layer 5 partially overlap with each other (as shown in FIG. 7). In some other embodiments, the third diffusion layer 4 and the fourth diffusion layer 5 completely overlap with each other (as shown in FIG. 8). In the present disclosure, the third diffusion layer 4 and the fourth diffusion layer 5 may have a large contact area, so that the solar cell has a large leakage current.

The third diffusion layer 4 may be in contact with the first diffusion layer 2, and the fourth diffusion layer 5 may be in contact with the second diffusion layer 3. Accordingly, the first diffusion layer 2 may be in contact with the fourth diffusion layer 5, and the second diffusion layer 3 may be in contact with the third diffusion layer 4.

In some embodiments, the third diffusion layer 4 is located between the semiconductor substrate 1 and the fourth diffusion layer 5. In other embodiments, the fourth diffusion layer 5 is located between the semiconductor substrate 1 and the third diffusion layer 4. The embodiments of the present disclosure do not limit the position of the third diffusion layer 4 and the fourth diffusion layer 5 at the side surface 1C of the semiconductor substrate 1, and only require that the third diffusion layer 4 and the fourth diffusion layer 5 at least partially overlap with each other.

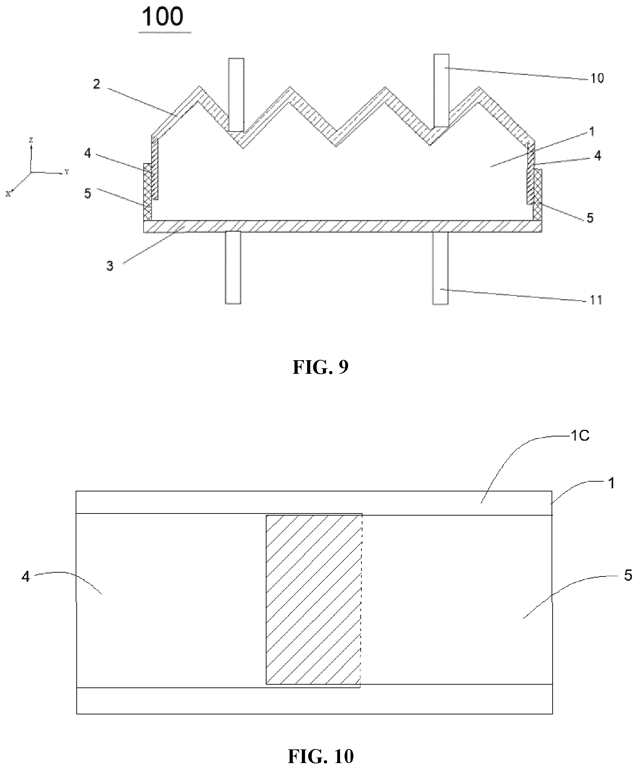

As shown in FIG. 7 and FIG. 8, the third diffusion layer 4 and the fourth diffusion layer 5 are not provided on the right side surface of the semiconductor substrate 1. As shown in FIG. 9, a schematic diagram of a structure in which the third diffusion layer 4 and the fourth diffusion layer 5 are provided on both the left and right surfaces of the semiconductor substrate 1. It can be understood that FIG. 7, FIG. 8 and FIG. 9 are schematic diagrams of a cross-sectional structure of a solar cell, which only show two side surfaces 1C, and the other two side surfaces 1C may also be provided with a third diffusion layer 4 and a fourth diffusion layer 5 that at least partially overlap with each other.

With reference to FIG. 10, which shows that a third diffusion layer 4 and a fourth diffusion layer 5 partially overlapping with each other are provided on a side surface of a semiconductor substrate 1. In some embodiments, a contact area (i.e., overlapping area) between the third diffusion layer 4 and the fourth diffusion layer 5 is represented by S2 (i.e., a shading area shown in FIG. 10), and an area of the side surface of the semiconductor substrate 1 in contact with the third diffusion layer 4 and the fourth diffusion layer 5 is represented by S3 (i.e., an area of the side surface 1C of the semiconductor substrate 1 shown in FIG. 10), where S2/S3=(0.1 to 1):1, and for example can be 0.1:1, 0.2:1, 0.25:1, 0.35:1, 0.5:1, 0.6:1, 0.75:1, 0.8:1, 0.9:1, or 1:1. The ratio of the two is the area ratio of the overlapping area between the third diffusion layer 4 and the fourth diffusion layer 5 to the area of the side surface of the semiconductor substrate 1. The present disclosure controls the above-mentioned area ratio to be within an appropriate range, the leakage current of the solar cell of the present disclosure at any voltage condition from 1V to 30V can be greater than 1A, thereby improving the overall output power of the photovoltaic module prepared by a plurality of the solar cells. Preferably, S2/S3=(0.3 to 0.9):1.

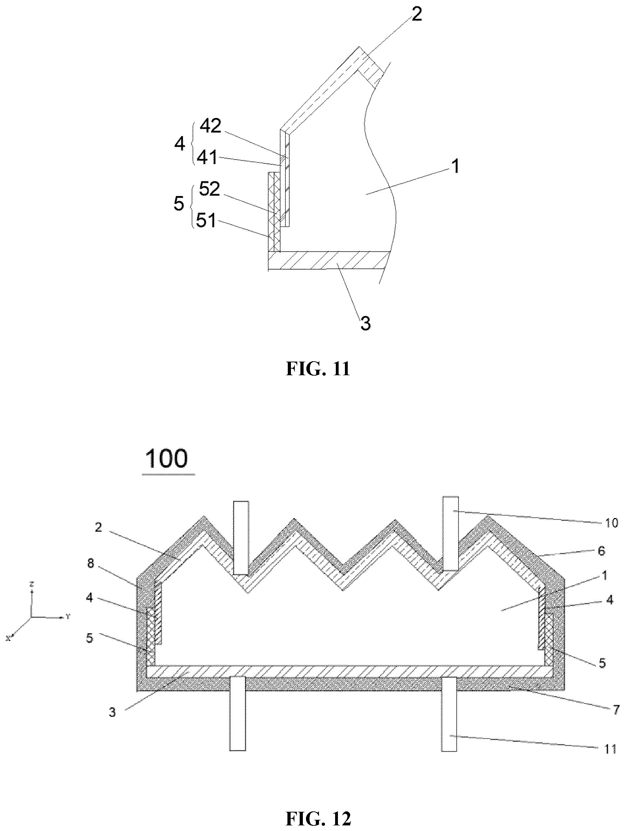

FIG. 11 is a structural schematic diagram of a part of a solar cell according to some embodiments of the present disclosure. In some embodiments, with reference to FIG. 11, the third diffusion layer 4 includes a third sublayer a41 and a third sublayer b42, the third sublayer a41 is farther away from the semiconductor substrate 1 than the third sublayer b42, and a doping concentration of the third sublayer a41 is less than a doping concentration of the third sublayer b42; and the fourth diffusion layer 5 includes a fourth sublayer b51 and a fourth sublayer b52, the fourth sublayer b51 is farther away from the semiconductor substrate 1 than the fourth sublayer b52, and a doping concentration of the fourth sublayer b51 is less than a doping concentration of the fourth sublayer b52. The effects of the above-described configuration have been described in detail above and will not be repeated herein.

In some embodiments, the doping concentration of the third sublayer a41 is 1*E17cm⁻³ to 1*E19cm⁻³, and for example may be 1*E17cm⁻³, 5*E17cm⁻³, 1*E18cm⁻³, 5*E18cm⁻³, or 1*E19cm⁻³, etc.

The doping concentration of the third sublayer b42 is 1*E18cm⁻³ to 5*E21cm⁻³, and for example may be 1*E18cm⁻³, 5*E18cm⁻³, 1*E19cm⁻³, 5*E19cm⁻³, 1*E20cm⁻³, or 5*E21cm⁻³, etc.

In some embodiments, the doping concentration of the fourth sublayer b51 is 1*E17cm⁻³ to 1*E19cm⁻³, and for example may be 1*E17cm⁻³, 5*E17cm⁻³, 1*E18cm⁻³, 5*E18cm⁻³, or 1*E19cm⁻³, etc.

The doping concentration of the fourth sublayer b52 is 1*E18cm⁻³ to 5*E21cm⁻³, and for example may be 1*E18cm⁻³, 5*E18cm⁻³, 1*E19cm⁻³, 5*E19cm⁻³, 1*E20cm⁻³, or 5*E21cm⁻³, etc.

Preferably, the third diffusion layer 4 and the fourth diffusion layer 5 each form a layer structure similar to gradient doping, which can reduce the recombination at the side surface 1C of the semiconductor substrate 1 and be beneficial to improving the photoelectric conversion efficiency of the solar cell.

In some embodiments, with reference to FIG. 12, a sum of the dimension of the third diffusion layer 4 along the second direction Y and the dimension of the fourth diffusion layer 5 along the second direction Y is within a range from 0.1 µm to 8 µm, for example, 0.1 µm, 0.5 µm, 1 µm, 3 µm, 5 µm or 8 µm, etc. The sum of the dimension of the third diffusion layer 4 along the second direction Y and the dimension of the fourth diffusion layer 5 along the second direction Y is the sum of the thickness of the third diffusion layer 4 and the thickness of the fourth diffusion layer 5. The present disclosure controls the sum of the thickness of the third diffusion layer 4 and the thickness of the fourth diffusion layer 5 to be within the above-mentioned range, so that the solar cell can act as a good diode device under normal working conditions, and at the same time has a large leakage current, thereby ensuring the output power of the solar cell under normal working conditions.

As mentioned above, the third diffusion layer and the fourth diffusion layer may have a patterned structure. In some embodiments, when the third diffusion layer 4 has a patterned structure and the fourth diffusion layer 5 does not have a patterned structure, and the third diffusion layer 4 is located between the semiconductor substrate 1 and the fourth diffusion layer 5, the third diffusion layer 4 includes a solid portion and a hollow portion in contact with the semiconductor substrate 1, and the fourth diffusion layer 5 is partially disposed at the hollow portion of the third diffusion layer 4 and partially disposed at the solid portion of the third diffusion layer 4, and the fourth diffusion layer 5 partially overlaps with the third diffusion layer 4 at the solid portion.

In some embodiments, when the third diffusion layer 4 has a patterned structure and the fourth diffusion layer 5 has a patterned structure, and the third diffusion layer 4 is located between the semiconductor substrate 1 and the fourth diffusion layer 5, the third diffusion layer 4 includes a solid portion and a hollow portion in contact with the semiconductor substrate 1, and the fourth diffusion layer 5 is entirely disposed at the solid portion of the third diffusion layer and partially overlaps with the third diffusion layer 4 at the solid portion.

In some embodiments, when the fourth diffusion layer 5 has a patterned structure and the third diffusion layer 4 does not have a patterned structure, and the fourth diffusion layer 5 is located between the semiconductor substrate 1 and the third diffusion layer 4, the fourth diffusion layer 5 includes a solid portion and a hollow portion in contact with the semiconductor substrate 1, and the third diffusion layer 4 is partially disposed at the hollow portion of the fourth diffusion layer 5 and partially disposed at the solid portion of the fourth diffusion layer 5, and the third diffusion layer 4 partially overlaps with the fourth diffusion layer 5 at the solid portion.

In some embodiments, when the fourth diffusion layer 5 has a patterned structure and the third diffusion layer 4 has a patterned structure, and the fourth diffusion layer 5 is disposed between the semiconductor substrate 1 and the third diffusion layer 4, the fourth diffusion layer 5 includes a solid portion and a hollow portion in contact with the semiconductor substrate 1, and the third diffusion layer 4 is entirely disposed at the solid portion of the fourth diffusion layer 5 and partially overlaps with the fourth diffusion layer 5 at the solid portion.

With reference to FIG. 12, the solar cell further includes a first passivation layer 6 disposed on a surface 1C of the first diffusion layer 2 facing away from the semiconductor substrate 1, a second passivation layer 7 disposed on a surface 1C of the second diffusion layer 3 facing away from the semiconductor substrate 1, and a third passivation layer 8 disposed on a surface 1C of the third diffusion layer 4 (or the fourth diffusion layer 5) facing away from the semiconductor substrate 1. It can be understood that when the third diffusion layer 4 is located between the semiconductor substrate 1 and the fourth diffusion layer 5, the third passivation layer 8 is located at a side of the fourth diffusion layer 5 facing away from the third diffusion layer 4. When the fourth diffusion layer 5 is located between the semiconductor substrate 1 and the third diffusion layer 4, the third passivation layer 8 is located at a side of the third diffusion layer 4 facing away from the fourth diffusion layer 5. In some embodiments, the third passivation layer 8 can be disposed at both a side of the third diffusion layer 4 and a side of the fourth diffusion layer 5.

In some embodiments, the material of the third passivation layer 8 may be the same as or different from the material of the first passivation layer 6. Preferably, the material of the third passivation layer 8 is the same as the material of the first passivation layer 6. In this case, the third passivation layer 8 and the first passivation layer 6 can be regarded as an integrated structure. Correspondingly, the material of the third passivation layer 8 may be the same as or different from the material of the second passivation layer 7. Preferably, the material of the third passivation layer 8 is the same as the material of the second passivation layer 7. In this case, the third passivation layer 8 and the second passivation layer 7 can be regarded as an integrated structure. The effects of the above-described configuration have been described in detail above and will not be repeated herein.

In some embodiments, the semiconductor substrate 1 is an N-type crystalline silicon substrate (or silicon wafer), and may also be a P-type crystalline silicon substrate (silicon wafer). The crystalline silicon substrate (silicon substrate) is, for example, one of a polycrystalline silicon substrate, a single crystal silicon substrate, a microcrystalline silicon substrate or a silicon carbide substrate. The embodiments of the present disclosure do not limit the specific type of the semiconductor substrate 1. When the semiconductor substrate 1 is a P-type semiconductor substrate, the doping element may be a Group-V element, for example phosphorus (P), arsenic (As), or tellurium (Te), etc. The N-type semiconductor substrate may form a PN junction with the first diffusion layer 2, or the N-type semiconductor substrate 1 may form a PN junction with the second diffusion layer 3. When the semiconductor substrate 1 is a P-type semiconductor substrate, the doping element may be a Group-III element for example boron (B), aluminum (Al), or gallium (Ga), etc. The P-type semiconductor substrate may form a PN junction with the first diffusion layer 2, or the P-type semiconductor substrate 1 may form a PN junction with the second diffusion layer 3.

The solar cell of the present disclosure includes, but is not limited to, aluminum back field solar cell, passivated emitter and rear cell (PERC), passivated emitter and rear totally-diffused cell (PERC), selective emitter (SE) solar cell, tunnel oxide passivated contact (TOPC) solar cell and heterojunction solar cell.

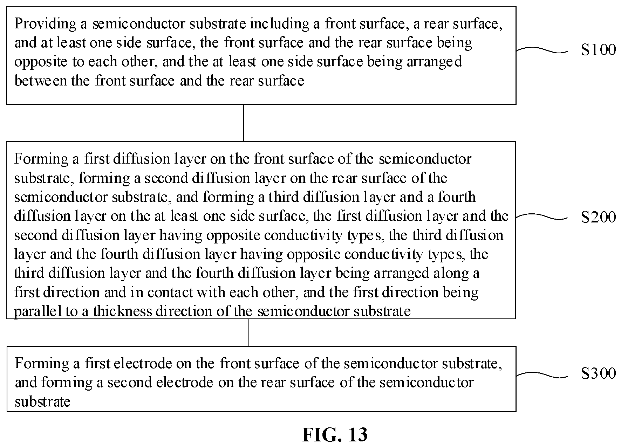

The present disclosure further provides a method for forming the above-mentioned solar cell. FIG. 13 shows a flow chart of a method for forming the solar cell provided by the embodiments of the present disclosure. As shown in FIG. 13, the method for forming the solar cell includes the following steps.

At S100, the semiconductor substrate 1 is provided and includes the front surface 1A, the rear surface 1B, and the at least one side surface 1C, the front surface 1A and the rear surface 1B are provided opposite to each other, and the at least one side surface 1C is provided between the front surface 1A and the rear surface 1B.

At S200, the first diffusion layer 2 is formed on the front surface 1A of the semiconductor substrate 1, the second diffusion layer 3 is formed on the rear surface 1B of the semiconductor substrate 1, and the third diffusion layer 4 and the fourth diffusion layer 5 are formed on the at least one side surface 1C of the substrate 1. The first diffusion layer 2 and the second diffusion layer 3 have opposite conductivity types. The third diffusion layer 4 and the fourth diffusion layer 5 have opposite conductivity types. The third diffusion layer 4 and the fourth diffusion layer 5 are provided along the first direction and in contact with each other, and the first direction is parallel to the thickness direction of the semiconductor substrate 1.

At S300, the first electrode 10 is formed at the front surface 1A of the semiconductor substrate 1. The second electrode 11 is formed at the rear surface 1B of the semiconductor substrate 1.

According to some embodiments of the present disclosure, the first diffusion layer 2 is formed on the front surface 1A of the solar cell, the second diffusion layer 3 is formed on the rear surface 1B, and the third diffusion layer 4 and the fourth diffusion layer 5 having opposite conductivity types and in contact with each other are formed on at least one side surface 1C, so that during a normal operation of the solar cell, since the third diffusion layer 4 and the fourth diffusion layer 5 are provided on the side surface 1C of the semiconductor substrate 1 and in contact with each other, the third diffusion layer 4 and the fourth diffusion layer 5 in contact with each other act as a diode to achieve unidirectional conduction, and at the same time have a large leakage current. If the solar cell is in an abnormal operation state (for example, when the solar cell is partially blocked or fails), the diode formed by the third diffusion layer 4 and the fourth diffusion layer 5 is caused to enter a reverse bias. At this time, the third diffusion layer 4 and the fourth diffusion layer 5 in contact with each other are equivalent to a resistor device, which allows current to pass through, so that when the current flows through a cell string including the solar cell, the cell string operation current can bypass the solar cell in the abnormal operation state to continue to flow through other solar cells directly through the path formed by the third diffusion layer 4 and the fourth diffusion layer 5, without affecting the use of the other solar cells, and at the same time, the other solar cells can also be protected from higher positive voltage bias. That is, when the solar cell of the present disclosure is applied to a photovoltaic module, the solar cell in an abnormal operation state can be removed/omitted from the cell string in which it is located, thereby ensuring the overall output power of the cell string in which the solar cell is located.

The method for forming the solar cell as shown in FIG. 13 of the present disclosure will be described below in conjunction with the accompanying drawings in the embodiments of the present disclosure. The described embodiments are only part of the embodiments of the present disclosure, rather than all the embodiments.

At S100, the semiconductor substrate 1 is provided. The structural schematic diagram of the semiconductor substrate 1 is shown in FIG. 2. The semiconductor substrate 1 includes the front surface 1A, the rear surface 1B, and the at least one side surface 1C. The front surface 1A and the rear surface 1B are provided opposite to each other, and the at least one side surface 1C is located between the front surface 1A and the rear surface 1B.

In some embodiments, the front surface 1A of the semiconductor substrate 1 corresponds to a front side of the cell, which is the surface facing the sunlight (i.e., the light-receiving surface), and the rear surface 1B of the semiconductor substrate 1 corresponds to a back side of the cell, which is the surface facing away from the sunlight (i.e., the backlight surface). The semiconductor substrate 1 generally includes four side surfaces 1C, which are respectively provided at a left side, a right side, a front side, and a back side of the semiconductor substrate 1.

In some embodiments, the semiconductor substrate 1 is an N-type crystalline silicon substrate (or silicon wafer), and may also be a P-type crystalline silicon substrate (silicon wafer). The crystalline silicon substrate (silicon substrate) is, for example, one of a polycrystalline silicon substrate, a single crystal silicon substrate, a microcrystalline silicon substrate, or a silicon carbide substrate. The embodiments of the present disclosure do not limit the specific type of the semiconductor substrate 1.

In some embodiments, a thickness of the semiconductor substrate 1 is 60 µm to 240 µm, and for example may be 60 µm, 80 µm, 90 µm, 100 µm, 120 µm, 150 µm, 200 µm or 240 µm, etc., no limitation is made herein.

In some embodiments, the front surface 1A and the rear surface 1B of the semiconductor substrate 1 may be textured to form a textured surface or a surface texture structure (for example, a pyramid structure). Preferably, the side surface 1C of the semiconductor substrate 1 may also be textured. The texturing may be performed by chemical etching, laser etching, mechanical etching, plasma etching, and the like, no limitation is made herein. Exemplarily, the front surface 1A and the rear surface 1B of the semiconductor substrate 1 may be textured by using a NaOH solution. Since the corrosion of the NaOH solution is anisotropic, pyramid texture structures can be formed in this way.

It can be understood that the surface of the semiconductor substrate 1 has a textured structure through the texturing process, thereby producing a light trapping effect, increasing the amount of light absorbed by the solar cell, and thus improving the conversion efficiency of the solar cell.

In some embodiments, prior to the texturing process, the method further includes a step of cleaning the semiconductor substrate 1, to remove metal and organic pollutants on the surface.

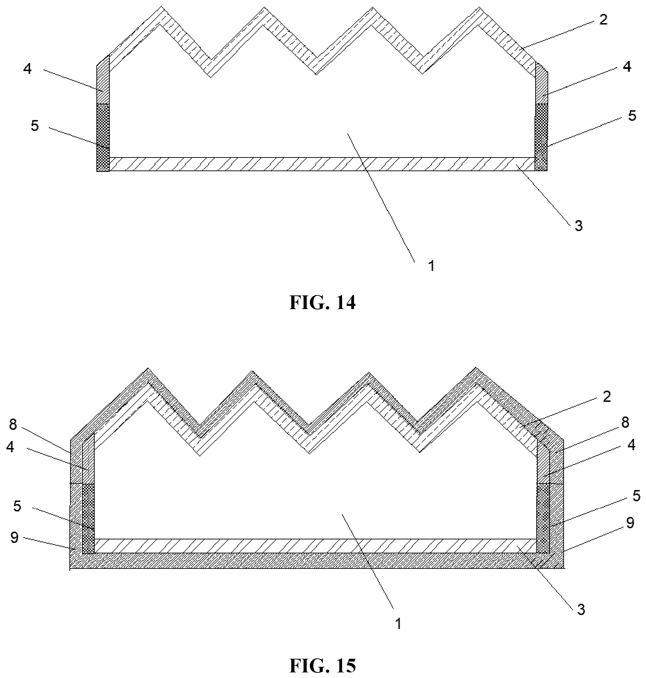

At S200, the first diffusion layer 2 is formed on the front surface 1A of the semiconductor substrate 1, the second diffusion layer 3 is formed on the rear surface 1B of the semiconductor substrate 1, and the third diffusion layer 4 and the fourth diffusion layer 5 are formed on at least one side surface 1C. The first diffusion layer 2 and the second diffusion layer 3 have opposite conductivity types, the third diffusion layer 4 and the fourth diffusion layer 5 have opposite conductivity types, the third diffusion layer 4 and the fourth diffusion layer 5 are arranged along the first direction and are in contact with each other, and the first direction is parallel to the thickness direction of the semiconductor substrate 1. The obtained structure is as shown in FIG. 14.

In some embodiments, a sequence for forming the first diffusion layer 2, the second diffusion layer 3, the third diffusion layer 4, and the fourth diffusion layer 5 is not limited and can be reasonably set according to the materials of the first diffusion layer 2, the second diffusion layer 3, the third diffusion layer 4, and the fourth diffusion layer 5. It can be understood that when the materials of the first diffusion layer 2 and the third diffusion layer 4 are the same, the first diffusion layer 2 and the third diffusion layer 4 can be formed by a same process to improve the manufacturing efficiency. Correspondingly, when the materials of the second diffusion layer 3 and the fourth diffusion layer 5 are the same, the second diffusion layer 3 and the fourth diffusion layer 5 can be formed by a same process.

In some embodiments, the first diffusion layer 2, the second diffusion layer 3, the third diffusion layer 4, and the fourth diffusion layer 5 can be obtained by directly performing diffusion treatments on the semiconductor substrate 1; or non-conductive layers can be formed on the front surface, the rear surface, and at least one side surface of the semiconductor substrate 1, and then diffusion treatments are performed on the non-conductive layers.

In some embodiments, the first diffusion layer 2, the second diffusion layer 3, the third diffusion layer 4, and the fourth diffusion layer 5 may be formed in or on (or at) the surface of the semiconductor substrate 1 by any one or more of a high temperature diffusion method, a slurry doping method, or an ion injection method.

A process for forming the first diffusion layer 2, the second diffusion layer 3, the third diffusion layer 4, and the fourth diffusion layer 5 are provided below, where the materials of the first diffusion layer 2 and the third diffusion layer 4 are the same, and the materials of the second diffusion layer 3 and the fourth diffusion layer 5 are the same. For example, the following steps are included:

At S201, a first diffusion treatment is performed on the entire semiconductor substrate 1, in such a manner that the first diffusion layer 2 and the first protective layer located at a surface of the first diffusion layer 2 are formed on each of the front surface 1A, the rear surface 1B, and at least one side surface 1C of the semiconductor substrate 1. It can be understood that when the first diffusion layer 2 is a phosphorus diffusion layer, the first protective layer is a phosphosilicate glass layer (PSG).

At S202, acid pickling is performed on the rear surface 1B and the side surface 1C of the semiconductor substrate 1 that are obtained at S201. In this process, the acid pickling process is controlled in such a manner that only a partial region of the side surface 1C of the semiconductor substrate 1 is pickled in the acid pickling process, so that the first diffusion layer 2 on the side surface 1C is transformed to be the third diffusion layer 4.

It can be understood that the first diffusion layer 2 on the side surface 1C and the third diffusion layer 4 on the side surface 1C differ only in what proportion they occupy on the side surface 1C of the semiconductor substrate 1, to remove the first protective layer from a part of the side surface 1C and the rear surface 1B of the semiconductor substrate 1.

In the present disclosure, the acid pickling process pickling a partial region of the side surface 1C of the semiconductor substrate 1 is mainly related to the dimension of the third diffusion layer 4 along the second direction. Those skilled in the art can configure a specific acid pickling process according to the preset dimension of the third diffusion layer 4 along the second direction.

In some embodiments, the acid pickling solution may be, for example, at least one of a hydrofluoric acid solution and a hydrochloric acid solution. Exemplarily, the acid pickling solution includes a hydrofluoric acid solution with a mass concentration of 2% to 10% and a hydrochloric acid solution with a mass concentration of 2% to 10%. The present disclosure does not limit the temperature and time of acid pickling, and those skilled in the art may make configurations according to actual needs.

It should be noted that water washing is needed after acid pickling; and of course, the semiconductor substrate 1 may further be dried after water washing.

At S203, the semiconductor substrate 1 obtained at S202 is etched to remove the first diffusion layer 2 from the rear surface 1B and a part of the side surface 1C of the semiconductor substrate 1.

At this step, the etching process may be at least one of wet etching, laser etching, chemical mechanical polishing, and plasma etching. The etching process mainly processes the region without the first protection layer.

At S204, a second diffusion treatment is performed on the semiconductor substrate 1 obtained at S203, such that the second diffusion layer 3 is formed on the rear surface 1B of the semiconductor substrate 1, the fourth diffusion layer 5 is formed on a part of the side surface 1C, and a second protective layer is formed at each of the surface of the second diffusion layer 3 and the fourth diffusion layer 5. It can be understood that when the second diffusion layer 3 is a boron diffusion layer, the second protective layer is a borosilicate glass layer (BSG).

At this step, in the second diffusion treatment process, it needs to control the formed fourth diffusion layer 5 and the third diffusion layer 4 at S202 to be in contact with each other.

It can be understood that the type of the doping element for the second diffusion treatment is different from the type of the doping element of the first diffusion layer 2, the second diffusion treatment can be performed by using a same, a similar, or a different process as that of the first diffusion layer 2, no limitation is made herein.

At S205, acid pickling is performed on the second protective layer on the rear surface 1B and a part of the side surface 1C of the semiconductor substrate 1 that are obtained at S204, to remove the second protective layer on the rear surface 1B and the side surface 1C of the semiconductor substrate 1.

In some embodiments, the acid pickling solution may be, for example, at least one of a hydrofluoric acid solution and a hydrochloric acid solution. Exemplarily, the acid pickling solution includes a hydrofluoric acid solution with a mass concentration of 2% to 10% and a hydrochloric acid solution with a mass concentration of 2% to 10%. The present disclosure does not limit the temperature and time of acid pickling, and those skilled in the art may make configurations according to actual needs.

It should be noted that water washing is needed after acid pickling; and of course, the semiconductor substrate 1 may further be dried after water washing.

In some embodiments, the side surface 1C of the semiconductor substrate 1 is textured in advance at S100 such that the third diffusion layer 4 and/or the fourth diffusion layer 5 formed at S200 has an uneven surface.

In some embodiments, the obtained third diffusion layer 4 and fourth diffusion layer 5 may be patterned after S205 to obtain the third diffusion layer 4 and the fourth diffusion layer 5 with patterned structures. It can be understood that the patterning process can be performed by at least one of laser processing and mask processing.

In some embodiments, it needs to form the first passivation layer 6 on the surface of the first diffusion layer 2, the second passivation layer 7 on the surface of the second passivation layer 7, the third passivation layer 8 on the surface of the third diffusion layer 4, and the fourth passivation layer 9 on the surface of the fourth diffusion layer 5. The obtained structure is as shown in FIG. 15. The above-mentioned passivation layer can reduce the minority carrier concentration at the surface of the semiconductor substrate 1 by the passivation effect, inhibit the carrier recombination at the surface of the cell, thereby reducing the surface recombination rate, and at the same time can reduce the series resistance and improve the electron transmission capacity.

In some embodiments, the process for forming the first passivation layer 6, the second passivation layer 7, the third passivation layer 8, and the fourth passivation layer 9 includes, but is not limited to, a thermal oxidation process, a plasma enhanced chemical vapor deposition process, an atomic layer deposition process and the like.

The materials and thicknesses of the first passivation layer 6, the second passivation layer 7, the third passivation layer 8, and the fourth passivation layer 9 may be the same as each other or different from each other. No limitation is made herein. Taking the first passivation layer 6 as an example, the first passivation layer 6 may include, but is not limited to, a single oxide layer or a multi-layer structure of silicon oxide, silicon nitride, silicon oxynitride, and aluminum oxide, etc. Of course, other type of passivation layer may also be adopt1ed. A thickness of the first passivation layer 6 is within a range of 10 nm to 100 nm, and for example may be 10 nm, 20 nm, 30 nm, 42 nm, 50 nm, 60 nm, 70 nm, 80 nm, 90 nm or 100 nm, etc. Of course, other value within the above-mentioned range is also possible, no limitation is made herein.

At S300, the first electrode 10 is formed at the front surface 1A of the semiconductor substrate 1, and the second electrode 11 is formed at the rear surface 1B of the semiconductor substrate 1, to obtain the solar cell. A structural schematic diagram of the solar cell is as shown in FIG. 3.

At this step, the first electrode 10 is obtained by performing metallization treatment on the front surface 1A or on the surface of the first passivation layer 6 of the semiconductor substrate 1, and the second electrode 11 is obtained by performing metallization treatment on the rear surface 1B or on the surface of the second passivation layer 7 of the semiconductor substrate 1.

In some embodiments, the first electrode 10 and the second electrode 11 may be formed respectively by using screen printing and sintering, to form ohmic contact between the first electrode 10 and the first diffusion layer 2 and ohmic contact between the second electrode 11 and the second diffusion layer 3; and of course, the first electrode 10 and the second electrode 11 may also be formed by using at least one of metal evaporation and electroplating.

It should be noted that the specific materials of the first electrode 10 and the second electrode 11 are not limited in the embodiments of the present disclosure. Exemplarily, the first electrode 10 may be a silver electrode or a silver/aluminum electrode, and the second electrode 11 may be a silver electrode.

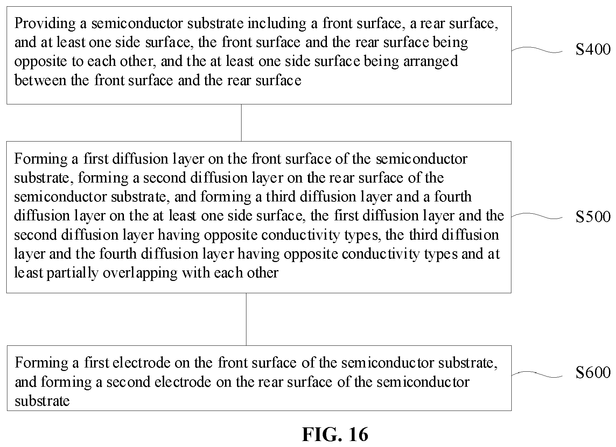

FIG. 16 shows a flow chart of a method for forming a solar cell according to some embodiments of the present disclosure. As shown in FIG. 16, the method for forming a solar cell includes the following steps.

At S400, the semiconductor substrate 1 is provided. The semiconductor substrate 1 includes the front surface 1A, the rear surface 1B, and the at least one side surface 1C. The front surface 1A and the rear surface 1B are provided opposite to each other, and the at least one side surface 1C is located between the front surface 1A and the rear surface 1B.

At S500, the first diffusion layer 2 is formed on the front surface 1A of the semiconductor substrate 1, the second diffusion layer 3 is formed on the rear surface 1B of the semiconductor substrate 1, and the third diffusion layer 4 and the fourth diffusion layer 5 are formed on at least one side surface 1C. The first diffusion layer 2 and the second diffusion layer 3 have opposite conductivity types, the third diffusion layer 4 and the fourth diffusion layer 5 have opposite conductivity types and at least partially overlap with each other.

At S600, the first electrode 10 is formed at the front surface 1A of the semiconductor substrate 1, and the second electrode 11 is formed on the back surface 1B of the semiconductor substrate 1.

In the above-described solution of the present disclosure, the first diffusion layer 2 is formed on the front surface 1A of the solar cell, the second diffusion layer 3 is formed on the rear surface 1B of the solar cell, and the third diffusion layer 4 and the fourth diffusion layer 5 having opposite conductivity types and at least partially overlapping with each other are formed on the side surface 1C of the semiconductor substrate 1, so that during a normal operation of the solar cell, since the third diffusion layer 4 and the fourth diffusion layer 5 are provided on the side surface 1C of the semiconductor substrate 1 and at least partially overlap with each other, the third diffusion layer 4 and the fourth diffusion layer 5 overlapping with each other act as a diode to achieve unidirectional conduction, and at the same time have a large leakage current. If the solar cell is in an abnormal operation state (for example, when the solar cell is partially blocked or fails), the diode formed by the third diffusion layer 4 and the fourth diffusion layer 5 is caused to enter a reverse bias. At this time, the third diffusion layer 4 and the fourth diffusion layer 5 at least partially overlapping with each other are equivalent to a resistor device, which allows a current to pass through, so that when the current flows through a cell string including the solar cell, the cell string operation current can bypass the solar cell in the abnormal operation state to continue to flow through other solar cells directly through the path formed by the third diffusion layer 4 and the fourth diffusion layer 5, without affecting the use of the other solar cells. That is, when the solar cell according to some embodiments of the present disclosure is applied to a photovoltaic module, the solar cell in the abnormal operation state can be removed/omitted from the cell string in which it is arranged, thereby ensuring the overall output power of the cell string in which the solar cell is located.

Next, the method for forming the solar cell in FIG. 16 will be described in the following in combination with the accompanying drawings in the embodiments of the present disclosure. The described embodiments are only some of the embodiments, rather than all of the embodiments of the present disclosure.

At S400, the semiconductor substrate 1 is provided. The structural schematic diagram of the semiconductor substrate 1 is shown in FIG. 2. The semiconductor substrate 1 includes the front surface 1A, the rear surface 1B, and the at least one side surface 1C. The front surface 1A and the rear surface 1B are provided opposite to each other, and the at least one side surface 1C is located between the front surface 1A and the rear surface 1B. The step S400 is the same as the above-mentioned step S 100 and will not be described again herein.

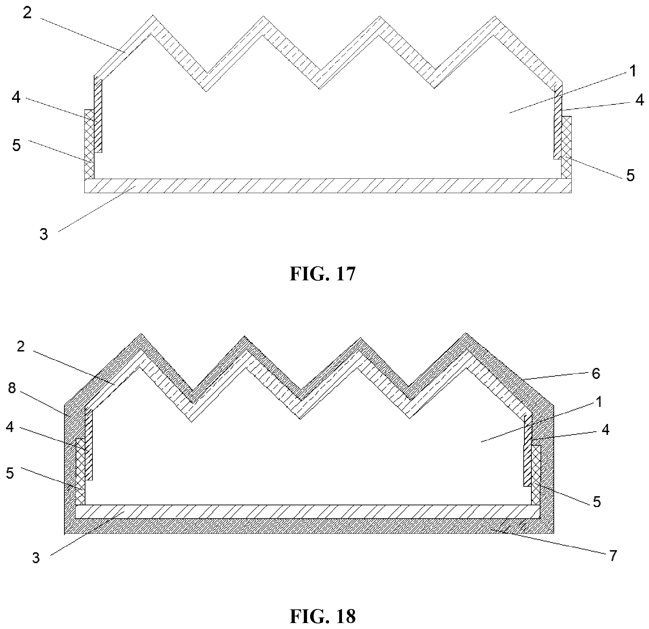

At S500, the first diffusion layer 2 is formed on the front surface 1A of the semiconductor substrate 1, the second diffusion layer 3 is formed on the rear surface 1B of the semiconductor substrate 1, and the third diffusion layer 4 and the fourth diffusion layer 5 are formed on at least one side surface 1C. The first diffusion layer 2 and the second diffusion layer 3 have opposite conductivity types, the third diffusion layer 4 and the fourth diffusion layer 5 have opposite conductivity types and at least partially overlap with each other. The obtained structure is as shown in FIG. 17.

In some embodiments, a sequence for forming the first diffusion layer 2, the second diffusion layer 3, the third diffusion layer 4, and the fourth diffusion layer 5 is not limited and can be reasonably set according to the materials of the first diffusion layer 2, the second diffusion layer 3, the third diffusion layer 4, and the fourth diffusion layer 5 and the forming process thereof.

The method for forming the first diffusion layer 2, the second diffusion layer 3, the third diffusion layer 4 and the fourth diffusion layer 5 have been described above and will not be described again herein.

A process for forming the first diffusion layer 2, the second diffusion layer 3, the third diffusion layer 4, and the fourth diffusion layer 5 are provided below, where the materials of the first diffusion layer 2 and the third diffusion layer 4 are the same, and the materials of the second diffusion layer 3 and the fourth diffusion layer 5 are the same. For example, the following steps are included.

At S501, a first diffusion treatment is performed on the entire semiconductor substrate 1, in such a manner that the first diffusion layer 2 and the first protective layer located at a surface of the first diffusion layer 2 are formed on each of the front surface 1A, the rear surface 1B, and at least one side surface 1C of the semiconductor substrate 1. It can be understood that when the first diffusion layer 2 is a phosphorus diffusion layer, the first protective layer is a phosphosilicate glass layer (PSG).

At S502, acid pickling is performed on the rear surface 1B or the rear surface 1B and a part of the side surface 1C of the semiconductor substrate 1 that are obtained at S501, so that the first diffusion layer 2 on the side surface 1C is transformed to be the third diffusion layer 4.

It can be understood that the first diffusion layer 2 on the side surface 1C and the third diffusion layer 4 on the side surface 1C differ only in what proportion they occupy on the side surface 1C of the semiconductor substrate 1, to remove the first protective layer from a part of the side surface 1C and the rear surface 1B of the semiconductor substrate 1.

In some embodiments, the acid-pickling process may only remove the first protective layer on the rear surface 1B of the semiconductor substrate 1; or the acid-pickling process may remove the first protective layer on the rear surface 1B of the semiconductor substrate 1 and a part of the side surface 1C of the semiconductor substrate 1. The acid-pickling process is mainly related to the area ratio of the third diffusion layer 4 on the side surface 1C. Those skilled in the art may configure an acid-pickling process according to a preset area ratio of the third diffusion layer 4 on the side surface 1C.

In some embodiments, the acid pickling solution may be, for example, at least one of a hydrofluoric acid solution and a hydrochloric acid solution. Exemplarily, the acid pickling solution includes a hydrofluoric acid solution with a mass concentration of 2% to 10% and a hydrochloric acid solution with a mass concentration of 2% to 10%. The present disclosure does not limit the temperature and time of acid pickling, and those skilled in the art may make configurations according to actual needs.

At S503, the semiconductor substrate 1 obtained at S502 is etched to remove the first diffusion layer from the rear surface 1B of the semiconductor substrate 1, or remove the first diffusion layer 2 from the rear surface 1B and a part of the side surface 1C of the semiconductor substrate 1.

At this step, the etching process may be at least one of wet etching, laser etching, chemical mechanical polishing, and plasma etching. The etching process mainly processes the region without the first protection layer.

At S504, a second diffusion treatment is performed on the semiconductor substrate 1 obtained at S503, such that the second diffusion layer 3 is formed on the rear surface 1B of the semiconductor substrate 1, the fourth diffusion layer 5 is formed on a part of the side surface 1C, and a second protective layer is formed at each of the surface of the second diffusion layer 3 and the fourth diffusion layer 5. It can be understood that when the second diffusion layer 3 is a boron diffusion layer, the second protective layer is a borosilicate glass layer (BSG).

At this step, by controlling the second diffusion treatment process, the fourth diffusion layer 5 and the third diffusion layer 4 completely overlap with each other or partially overlap with each other.

It can be understood that the type of the doping element for the second diffusion treatment is different from the type of the doping element of the first diffusion layer 2, the second diffusion treatment can be performed by using a same, a similar, or a different process as that of the first diffusion layer 2, no limitation is made herein.

At S505, acid pickling is performed on the second protective layer on the rear surface 1B and the side surface 1C of the semiconductor substrate 1 that are obtained at S204, to remove the second protective layer on the rear surface 1B and the side surface 1C of the semiconductor substrate 1.

In some embodiments, the acid pickling solution may be, for example, at least one of a hydrofluoric acid solution and a hydrochloric acid solution. Exemplarily, the acid pickling solution includes a hydrofluoric acid solution with a mass concentration of 2% to 10% and a hydrochloric acid solution with a mass concentration of 2% to 10%. The present disclosure does not limit the temperature and time of acid pickling, and those skilled in the art may make configurations according to actual needs.

In some embodiments, the side surface 1C of the semiconductor substrate 1 is textured in advance at S400 such that the third diffusion layer 4 and/or the fourth diffusion layer 5 formed at S500 has an uneven surface.

In some embodiments, the third diffusion layer 4 obtained after S503 may be patterned, and/or the fourth diffusion layer 5 obtained after S505 may be patterned to form a patterned structure. It can be understood that the patterning process can be performed by at least one of laser processing and mask processing.

In some embodiments, it needs to form the first passivation layer 6 on the surface of the first diffusion layer 2, the second passivation layer 7 on the surface of the second passivation layer 7, the third passivation layer 8 on the surface of the fourth diffusion layer 5. The obtained structure is as shown in FIG. 18. The above-mentioned passivation layer can reduce the minority carrier concentration at the surface of the semiconductor substrate 1 by the passivation effect, inhibit the carrier recombination at the surface of the cell, thereby reducing the surface recombination rate, and at the same time can reduce the series resistance and improve the electron transmission capacity.

In some embodiments, the process for forming the first passivation layer 6, the second passivation layer 7, and the third passivation layer 8 includes, but is not limited to, a thermal oxidation process, a plasma enhanced chemical vapor deposition process, an atomic layer deposition process and the like. The materials and thicknesses of the first passivation layer 6, the second passivation layer 7, and the third passivation layer 8 may be the same as each other or different from each other. No limitation is made herein.

At S600, the first electrode 10 is formed at the front surface 1A of the semiconductor substrate 1, and the second electrode 11 is formed at the rear surface 1B of the semiconductor substrate 1, to obtain the solar cell. A structural schematic diagram of the solar cell is as shown in FIG. 12. The step S600 is the same as the above-mentioned step S300 and will not be described again herein.

It should be noted that, in the embodiments of the present disclosure, unless otherwise specified, each operation step may be performed in sequence or not. The sequence of the steps for forming the solar cell is not limited in the embodiments of the present disclosure, and can be adjusted according to the actual production process.

Some embodiments of the present disclosure provide a photovoltaic module 1000, including a cell string formed by electrically connecting a plurality of solar cells described above.

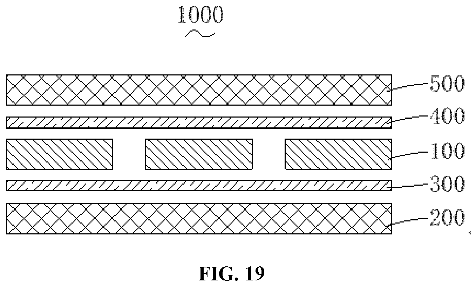

For example, with reference to FIG. 19, the photovoltaic module 1000 includes a first cover plate 200, a first encapsulation adhesive layer 300, a solar cell string, a second encapsulation adhesive layer 400, and a second cover plate 500.

In some embodiments, the solar cell string includes a plurality of solar cells 100 as described above connected by electric-conductive belts, and the plurality of solar cells 100 may be connected in series and/or in parallel with each other. The solar cells 100 may be connected by partial stacking or splicing with each other. As such, during the operation of the photovoltaic module, once a certain solar cell is in an abnormal operation state, the cell string operation current can continue to flow through other solar cells directly through the path formed by the third diffusion layer and the fourth diffusion layer, without affecting the use of the other solar cells in the cell string, thereby ensuring the overall output power of the cell string in which the solar cell is located.

In some embodiments, each of the first cover plate 200 and the second cover plate 500 may be a transparent or an opaque cover plate, for example, a glass cover plate or a plastic cover plate.

Two sides of the first encapsulation adhesive layer 300 are in contact with and fitted to the first cover plate 200 and the cell string, respectively; and two sides of the second encapsulation adhesive layer 400 are in contact with and fitted to the second cover plate 500 and the cell string. Each of the first encapsulation adhesive layer 300 and the second encapsulation adhesive layer 400 may be an ethylene-vinyl acetate copolymer (EVA) adhesive film, a polyolefin elastomer (POE) adhesive film, or a polyethylene terephthalate (PET) adhesive film.

The photovoltaic module 1000 may be encapsulated in a side- enclosed manner, that is, the sides of the photovoltaic module 1000 are completely encapsulated by an encapsulating belt to prevent the phenomenon that the lamination of the photovoltaic module 1000 shifts during the lamination process.

The photovoltaic module 1000 further includes an edge encapsulation component, which is fixedly encapsulated to a portion of the edge of the photovoltaic module 1000. The edge encapsulation component can be fixedly encapsulated at the edge of the photovoltaic module 1000 near a corner. The edge encapsulation component may be a high temperature resistant adhesive tape. The high temperature resistant tape has superior high temperature resistance and will not decompose or fall off during the lamination process, thereby being capable of ensuring reliable encapsulation of the photovoltaic module 1000. Two ends of the high temperature resistant tape are fixed to the second cover plate 500 and the first cover plate 200, respectively. The two ends of the high temperature resistant tape can be bonded to the second cover plate 500 and the first cover plate 200, respectively, while a middle part thereof can limit the side of the photovoltaic module 1000 to prevent that the lamination of the photovoltaic module 1000 shifts during the lamination process.

The above description merely illustrates preferred embodiments of the present disclosure and is not intended to limit the present disclosure. For those skilled in the art, the present disclosure may have various modifications and changes. Any modifications, equivalent substitutions, improvements, etc. made within a concept or principle of the present disclosure shall fall within a scope of the present disclosure.

## Claims

1. A solar cell (100), comprising:
a semiconductor substrate (1) comprising a front surface (1A), a rear surface (1B), and at least one side surface (1C), wherein the front surface (1A) and the rear surface (1B) are opposite to each other, and the at least one side surface (1C) is arranged between the front surface (1A) and the rear surface (1B);
a first diffusion layer (2) located inside or on the front surface (1A) of the semiconductor substrate (1);
a second diffusion layer (3) located inside or on the rear surface (1B) of the semiconductor substrate (1), wherein the first diffusion layer (2) and the second diffusion layer (3) have opposite conductivity types;
a third diffusion layer (4) and a fourth diffusion layer (5) that are located on the at least one side surface (1C), wherein the third diffusion layer (4) and the fourth diffusion layer (5) have opposite conductivity types, and the third diffusion layer (4) and the fourth diffusion layer (5) are in contact with each other;
a first electrode (10) forming ohmic contact with the first diffusion layer (2); and
a second electrode (11) forming ohmic contact with the second diffusion layer (3).

2. The solar cell (100) according to claim 1, wherein the third diffusion layer (4) and the fourth diffusion layer (5) are arranged along a first direction (Z), and the first direction (Z) is parallel to a thickness direction of the semiconductor substrate (1);
the third diffusion layer (4) is in contact with the first diffusion layer (2); and/or
the fourth diffusion layer (5) is in contact with the second diffusion layer (3).

3. The solar cell (100) according to claim 2, wherein a dimension of the third diffusion layer (4) along the first direction (Z) is represented by L1, and a dimension of the fourth diffusion layer (5) along the first direction (Z) is represented by L2, where L1/L2=(0.5 to 1.5):1.

4. The solar cell (100) according to claim 2, wherein a contact area between the third diffusion layer (4) and the fourth diffusion layer (5) is represented by S1, and an area of the side surface (1C) of the semiconductor substrate (1) in contact with the third diffusion layer (4) and the fourth diffusion layer (5) is represented by S0, where S1/S0=(0.1 to 0.9):1.

5. The solar cell (100) according to claim 1, wherein the third diffusion layer (4) and the fourth diffusion layer (5) are arranged along a second direction, and the third diffusion layer (4) and the fourth diffusion layer (5) at least partially overlap with each other,
the third diffusion layer (4) is located between the semiconductor substrate (1) and the fourth diffusion layer (5), or the fourth diffusion layer (5) is located between the semiconductor substrate (1) and the third diffusion layer (4);
the third diffusion layer (4) is in contact with the first diffusion layer (2), and/or the third diffusion layer (4) is in contact with the second diffusion layer (3);
the fourth diffusion layer (5) is in contact with the first diffusion layer (2), and/or the fourth diffusion layer (5) is in contact with the second diffusion layer (3); and
the second direction is perpendicular to the first direction (Z), and the second direction is perpendicular to the thickness direction of the semiconductor substrate (1).

6. The solar cell (100) according to claim 5, wherein a sum of a dimension of the third diffusion layer (4) along the second direction and a dimension of the fourth diffusion layer (5) along the second direction is within a range from 0.1 µm to 8 µm.

7. The solar cell (100) according to claim 5, wherein a contact area between the third diffusion layer (4) and the fourth diffusion layer (5) is represented by S2, and an area of the side surface (1C) of the semiconductor substrate (1) in contact with the third diffusion layer (4) or the fourth diffusion layer (5) is represented by S3, where S2/S3=(0.1 to 1): 1.

8. The solar cell (100) according to any one of claims 1 to 7, wherein the third diffusion layer (4) comprises a doping element, and a doping concentration of the third diffusion layer (4) is within a range from 1*E17cm⁻³ to 5*E21cm⁻³; and/or
the fourth diffusion layer (5) comprises a doping element, and a doping concentration of the fourth diffusion layer (5) is within a range from 1*E17cm⁻³ to 5*E21cm⁻³.

9. The solar cell (100) according to any one of claims 1 to 8,
wherein the third diffusion layer (4) comprises a third sublayer a (41) and a third sublayer b (42), the third sublayer a (41) is farther away from the semiconductor substrate (1) than the third sublayer b (42), and a doping concentration of the third sublayer a (41) is less than a doping concentration of the third sublayer b (42); and/or
wherein the fourth diffusion layer (5) comprises a fourth sublayer a (51) and a fourth sublayer b (52), the fourth sublayer a (51) is farther away from the semiconductor substrate (1) than the fourth sublayer b (52), and a doping concentration of the fourth sublayer a (51) is lower than a doping concentration of the fourth sublayer b (52).

10. The solar cell (100) according to any one of claims 1 to 9,
wherein a dimension of the third diffusion layer (4) along a second direction is within a range from 0.05 µm to 5 µm; and/or a dimension of the fourth diffusion layer (5) along a second direction is within a range from 0.05 µm to 5 µm.

11. The solar cell (100) according to any one of claims 1 to 10,
wherein the third diffusion layer (4) and the first diffusion layer (2) have a same conductivity type; and/or
wherein the fourth diffusion layer (5) and the second diffusion layer (3) have a same conductivity type.

12. The solar cell (100) according to any one of claims 1 to 11, wherein the third diffusion layer (4) and/or the fourth diffusion layer (5) has an uneven surface.

13. The solar cell (100) according to any one of claims 1 to 12, wherein a leakage current of the solar cell (100) is greater than or equal to 1A at any voltage condition from 1V to 30V.

14. A method for forming a solar cell (100), comprising:
providing (S100, S400) a semiconductor substrate (1) comprising a front surface (1A), a rear surface (1B), and at least one side surface (1C), wherein the front surface (1A) and the rear surface (1B) are opposite to each other, and the side surface (1C) is arranged between the front surface (1A) and the rear surface (1B);
forming (S200, S500) a first diffusion layer (2) on the front surface (1A) of the semiconductor substrate (1), forming a second diffusion layer (3) on the rear surface (1B) of the semiconductor substrate (1), and forming a third diffusion layer (4) and a fourth diffusion layer (5) on the at least one side surface (1C), wherein the first diffusion layer (2) and the second diffusion layer (3) have opposite conductivity types, the third diffusion layer (4) and the fourth diffusion layer (5) have opposite conductivity types, and the third diffusion layer (4) and the fourth diffusion layer (5) are in contact with each other; and
forming (S300, S600) a first electrode (10) on the front surface (1A) of the semiconductor substrate (1), and forming a second electrode (11) on the rear surface (1B) of the semiconductor substrate (1).

15. A photovoltaic module, comprising:
a cover plate;
an encapsulating material layer; and
a solar cell (100) string comprises a plurality of the solar cell (100)s according to any one of claims 1 to 13 or a plurality of the solar cell (100)s formed by the method according to claim 14.
